(19) **Europäisches Patentamt / European Patent Office / Office européen des brevets**

(11) **EP 4 686 357 A1**

(12) # EUROPEAN PATENT APPLICATION

(43) Date of publication:
**28.01.2026 Bulletin 2026/05**

(21) Application number: **25172617.0**

(22) Date of filing: **25.04.2025**

(51) International Patent Classification (IPC):
**H10K 59/121** (2023.01) **H10K 59/35** (2023.01)
**H10K 59/38** (2023.01) **H10K 59/80** (2023.01)
**H10K 50/86** (2023.01)

(52) Cooperative Patent Classification (CPC):
**H10K 59/121; H10K 59/353; H10K 59/38; H10K 59/8792**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **25.07.2024 KR 20240098560**

(71) Applicant: **Samsung Display Co., Ltd**
**Yongin-si, Gyeonggi-do (KR)**

(72) Inventors:
• **Kim, Chan Young**
**Yongin-si, Gyeonggi-do (KR)**
• **Choi, Beohm Rock**
**Yongin-si, Gyeonggi-do (KR)**
• **Im, Choongyoul**
**Yongin-si, Gyeonggi-do (KR)**
• **Jeon, Ha Seok**
**Yongin-si, Gyeonggi-do (KR)**
• **Cho, Seong Min**
**Yongin-si, Gyeonggi-do (KR)**

(74) Representative: **Gulde & Partner**
**Patent- und Rechtsanwaltskanzlei mbB**
**Berliner Freiheit 2**
**10785 Berlin (DE)**

(54) **DISPLAY DEVICE, AND ELECTRONIC DEVICE INCLUDING THE DISPLAY DEVICE**

(57)    A display device includes a display panel including a display region having a first resolution, and a component region having a different second resolution, and including a light-transmitting region, a pixel-defining layer overlapping an anode, and defining light-emitting regions including first light-emitting regions at the display region, and having a first aperture ratio, and second light-emitting regions at the component region, and having a different second aperture ratio, light-emitting elements at the light-emitting regions, a cathode above the pixel-defining layer and the light-emitting elements, an encapsulation layer above the cathode, a light-blocking member above the encapsulation layer, in the component region, entirely overlapping the light-transmitting region, and defining openings overlapping the light-emitting regions, and color filters at the openings of the light-blocking member, and overlapping the light-emitting regions, and an optical element on a rear surface of the component region.

FIG. 6

EP 4 686 357 A1

**Description**

**BACKGROUND**

**1. Field**

The present disclosure relates to a display device.

**2. Description of the Related Art**

A display device is a device that displays a screen, and includes a liquid crystal display (LCD) device, an organic light-emitting diode (OLED) device, and the like. Such a display device is used in various electronic devices, such as a mobile phone, a navigation device, a digital camera, an electronic book, a portable game machine, or various terminals.

A display device, such as an organic light-emitting display device may have a structure in which the display device may be bent or folded using a flexible substrate.

Furthermore, in small electronic devices, such as mobile phones, optical elements, such as cameras and optical sensors, were formed in the bezel region around the display region, but as the size of the display screen is increased, the size of the surrounding region of the display region gradually decreases, technology is being developed to allow cameras or optical sensors to be positioned at the rear surface of the display region.

**SUMMARY**

The present disclosure provides a display device in which pixels located in a display region in a display device and pixels located in a component region located in front of a sensor have the same luminance and lifetime.

A display device according to one or more embodiments includes a display panel including a display region having a first resolution, and a component region surrounded by the display region in plan view, having a second resolution that is different from the first resolution based on a same area, and including a light-transmitting region, a pixel-defining layer overlapping an anode, and defining light-emitting regions including first light-emitting regions in the display region, and having a first aperture ratio, and second light-emitting regions in the component region, and having a second aperture ratio that is different from the first aperture ratio based on a same area ,a light-emitting layer in each of the light-emitting regions, a cathode above the pixel-defining layer and the light-emitting elements, an encapsulation layer above (e.g. directly disposed on) the cathode, a light-blocking member above (e.g. disposed on) the encapsulation layer, the light-blocking member entirely overlapping the light-transmitting region in the component region, and defining openings overlapping the light-emitting regions, and color filters at the openings of the light-blocking member (i.e. completely covering the openings of the light-blocking member), and overlapping the light-emitting regions, and an optical element on a rear surface of the component region.

The first aperture ratio may be less than the second aperture ratio, wherein the first resolution is greater than the second resolution.

A Z value, which is expressed by $Z=(X0/X1)*(Y0/Y1)$, may be greater than about 0.5 and less than or equal to about 1, X0 being the first aperture ratio, X1 being the second aperture ratio, Y0 being the second resolution, and Y1 being the first resolution.

The cathode may define a first opening overlapping the light-transmitting region.

The pixel-defining layer may entirely overlap the light-transmitting region, wherein the pixel-defining layer in the component region overlaps the light-blocking member. The pixel-defining layer may entirely overlap the light-transmitting region, wherein the light-blocking member overlaps the pixel-defining layer in the component region.

The pixel-defining layer may include a black pixel-defining layer.

The pixel-defining layer may define a second opening overlapping the light-transmitting region.

A first planar shape of the first light-emitting regions may be different from a second planar shape of the second light-emitting regions.

The first planar shape may include an ellipse or a circle, wherein the second planar shape includes a square.

A first planar arrangement of the first light-emitting regions and a second planar arrangement of the second light-emitting regions may be different.

The first light-emitting regions and the second light-emitting regions may have a curved planar shape including an ellipse or a circle, wherein the first light-emitting regions and the second light-emitting regions have a same planar arrangement.

The component region may include a first component region and a second component region including light-transmitting regions, wherein a number, density, or size of one of the light-transmitting regions at the first component region is different from that of one of the light-transmitting regions at the second component region.

The display device may further include third light-emitting regions having the first aperture ratio at the second component region, wherein the second light-emitting regions at the first component region, and wherein a resolution of the first light-emitting regions is substantially equal to a resolution of the third light-emitting regions based on a same area.

The light-blocking member may include two or more of the color filters.

The two or more of the color filters may comprise a red color filter and a blue color filter.

According to the embodiments, it is possible to provide a display device in which pixels positioned in the display region and the component region have similar or equal luminance and lifetime, while maintaining light transmittance of the component region.

## BRIEF DESCRIPTION OF THE DRAWINGS

FIG. 1 is a perspective view illustrating a use state of a display device according to one or more embodiments.

FIG. 2 is an exploded perspective view of a display device according to one or more embodiments.

FIG. 3 is a block diagram of a display device according to one or more embodiments.

FIG. 4 is a perspective view illustrating a display device according to some embodiments.

FIG. 5 is an enlarged plan view illustrating a partial region of a display device according to one or more embodiments.

FIG. 6 is an enlarged plan view illustrating a display region and a first component region of a display device according to one or more embodiments.

FIG. 7 is a plan view illustrating a partial region of FIG. 5.

FIG. 8 is an enlarged plan view illustrating a display region and a second component region according to one or more embodiments.

FIG. 9 is a cross-sectional view taken along the line I-I' of FIG. 6.

FIG. 10 is a cross-sectional view taken along the line II-II' of FIG. 6.

FIG. 11 is an enlarged plan view illustrating a display region and a first component region of a display device according to some embodiments.

FIG. 12 is a cross-sectional view taken along the line II-II' of FIG. 6 according to some embodiments.

FIGS. 13 to 15 are enlarged plan views illustrating a display region and a first component region of a display device according to some embodiments.

FIGS. 16 and 19 are cross-sectional views taken along the line I-I' of FIG. 6 according to some embodiments.

FIGS. 17, 18, and 20 are cross-sectional views taken along the line II-II' of FIG. 6 according to some embodiments.

FIG. 21 is a block diagram of an electronic device according to one or more embodiments.

FIGS. 22 to 24 are schematic views of electronic devices according to various embodiments.

## DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, the disclosure is not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component (e.g., an apparatus, a device, a circuit, a wire, an electrode, a terminal, a conductive film, etc.) is referred to as being "formed on," "on," "connected to," or "(operatively, functionally, or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a transistor, a resistor, an inductor, a capacitor, a diode and/or the like. Accordingly, a connection is not limited to the connections illustrated in the drawings or the detailed description and may also include other types of connections. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XY, YZ, and XZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within $\pm$ 30%, 20%, 10%, 5% of the stated value. Further, the use of "may" when describing embodiments of the present disclosure refers to "one or more embodiments of the present disclosure." Furthermore, the expression "being the same" may mean "being substantially the same". In other words, the expression "being the same" may include a range that can be tolerated by those of ordinary skill in the art. The other expressions may also be expressions from which "substantially" has been omitted.

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

In addition, when a part of wiring, layer, film, region, substrate, component, etc. is referred to as "extending in the first or second direction", this does not mean only a straight line shape extending straight in the corresponding direction, but also includes a structure that is generally extended along the first direction or the second direction and is bent in a part, has a zigzag structure, or extends while including a curved structure.

In addition, electronic devices (e.g., mobile phones, TVs, monitors, laptops, etc.) including display devices and display panels described in the specification, or electronic devices including display devices and display panels manufactured by the manufacturing method described in the specification, are not excluded from the scope of the specification.

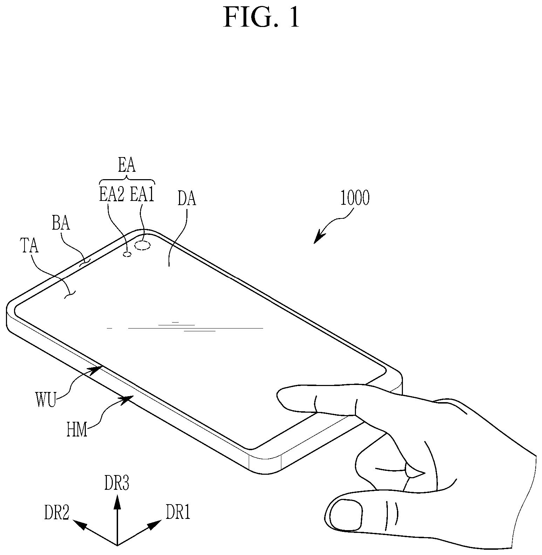

Hereinafter, a schematic structure of a display device will be described with reference to FIGS. 1 to 3.

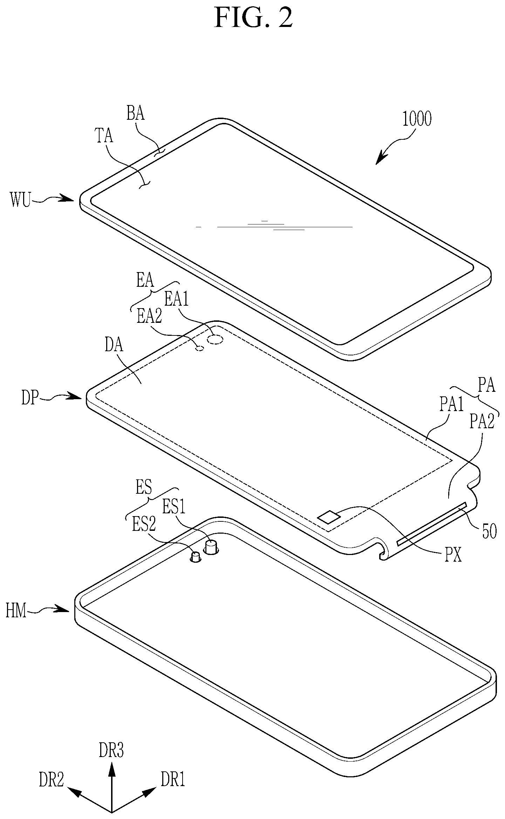

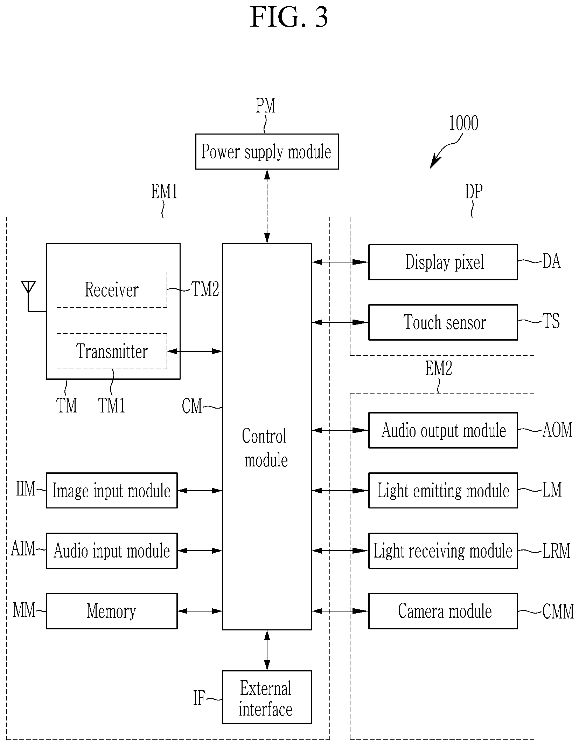

FIG. 1 is a perspective view illustrating a use state of a display device according to one or more embodiments. FIG. 2 is an exploded perspective view of a display device according to one or more embodiments. FIG. 3 is a block diagram of a display device according to one or more embodiments.

Referring to FIG. 1, a display device 1000 according to one or more embodiments is a device for displaying a video or still image, and may be used as a display screen for various products, such as television, laptops, monitors, billboards, Internet of Things (IoTs), as well as portable electronic devices, such as mobile phone, smart phone, tablet personal computer (PC), mobile communication terminal, electronic notebook, electronic book, portable multimedia player PMP, navigation system, and ultra mobile PC UMPC. In addition, the display device 1000 according to one or more embodiments may be used in wearable devices, such as smart watches, watch phones, glasses-type displays, head-mounted displays HMDs, virtual reality (VR) devices, or augmented reality (AR) devices. In addition, the display device 1000 according to one or more embodiments may be used as a dashboard of a vehicle, a center information display (CID) located in a center fascia or a dashboard of the vehicle, a room mirror display replacing a side mirror of the vehicle, an entertainment element for a rear seat of the vehicle, and a display located on a rear surface of the front seat. For convenience of description, FIG. 1 illustrates that the display device 1000 is used as a smart phone.

The display device 1000 may display an image toward a third direction DR3 on a display surface parallel to each of first and second directions DR1 and DR2. The display surface on which the image is displayed may correspond to the front surface of the display device 1000, and may correspond to the front surface of the cover window WU. The image may include a moving image, as well as a still image.

A front surface (or an upper surface) and a rear surface (or a lower surface) of each member may be defined with respect to a direction in which an image is displayed. The front surface and the rear surface may be opposite to each other in the third direction DR3, and the normal direction of each of the front surface and the rear surface may be parallel to the third direction DR3. A separation distance between the front surface and the rear surface in the third direction DR3 may correspond to a thickness of the display panel in the third direction DR3.

The display device 1000 according to one or more embodiments may detect a user's input (refer to hand in FIG. 1) applied from the outside. The user's input may include various types of external inputs, such as a part of the user's body, light, heat, or pressure. In one or more embodiments, the user's input is shown by the user's hand applied to the front surface. However, the present disclosure is not limited thereto. The user's input may be provided in various forms, and the display device 1000 may detect a user's input applied to the side surface or rear surface of the display device 1000 according to the structure of the display device 1000.

Referring to FIGS. 1 and 2, the display device 1000 may include a cover window WU, a housing HM, a display panel DP, and an optical element ES. In one or more embodiments, the cover window WU and the housing HM may be coupled to form an external appearance of the display device 1000.

The cover window WU may include an insulating panel. For example, the cover window WU may include glass, plastic, or a combination thereof.

A front surface of the cover window WU may define a front surface of the display device 1000. The transmitting region TA may be an optically transparent region. For example, the transmitting region TA may be a region having a visible light transmittance of about 90% or more.

The blocking region BA may define a shape of the transmitting region TA. The blocking region BA may be adjacent to the transmitting region TA, and may surround the transmitting region TA. The blocking region BA may be a region having a relatively low light transmittance compared to the transmitting region TA. The blocking region BA may include an opaque material that blocks light. The blocking region BA may have a corresponding color. The blocking region BA may be defined by a bezel layer provided separately from the transparent substrate defining the transmitting region TA, or may be defined by an ink layer formed by being inserted into or colored in the transparent substrate.

The display panel DP may include a display region DA for displaying an image and a driver 50. The display panel DP may include a front surface including a display area DA and a non-display area PA. The display region DA may be a region in which a pixel operates according to an electrical signal to emit light.

In one or more embodiments, the display region DA may be a region in which an image is displayed including a pixel, and at the same time, may be a region where external input is detected by a touch sensor positioned on top of the pixel in the third direction DR3.

The transmitting region TA of the cover window WU may at least partially overlap the display region DA of the display panel DP. For example, the transmitting region TA may overlap the front surface of the display region DA or may overlap at least a portion of the display region DA.

Accordingly, the user may view an image through the transmitting region TA, or may provide an external input based on the image. However, the present disclosure is not limited thereto, and may be variously changed. For example, a region where an image is displayed and a region where an external input is sensed may be separated from each other in the display region DA.

The non-display region PA of the display panel DP may at least partially overlap the blocking region BA of the cover window WU. The non-display region PA may be a region covered by the blocking region BA. The non-display region PA is adjacent to the display region DA and may surround the display region DA. An image is not displayed in the non-display region PA, and a driving circuit or driving wire for driving the display region DA may be positioned. The non-display region PA may include a first peripheral region PA1 where the display region DA is positioned outside, and a second peripheral region PA2 including a driver 50, a connection wire, and a bending region. In the one or more embodiments corresponding to FIG. 2, the first peripheral region PA1 is positioned on the three peripheries of the display region DA, and the second peripheral region PA2 is positioned on the other periphery of the display region DA.

In one or more embodiments, the display panel DP may be assembled in a flat state in which the display region DA and the non-display region PA face the cover window WU. However, the present disclosure is not limited thereto, and may be variously changed. A part of the non-display region PA of the display panel DP may be bent. Some of the non-display regions PA face the rear surface of the display device 1000, so that the blocking region BA shown on the front surface of the display device 1000 may be reduced, and in FIG. 2, the second peripheral region PA2 may be bent and positioned on the rear surface of the display region DA, and then assembled.

Also, the display panel DP may include a component region EA. The component region EA may include a first component region EA1 and a second component region EA2. The first component region EA1 and the second component region EA2 may be at least partially surrounded by the display region DA. Although the first component region EA1 and the second component region EA2 are shown to be spaced apart from each other, they are not limited thereto, and at least some of them may be connected to each other.

The first component region EA1 and the second component region EA2 may be regions in which a component using infrared, visible light, or sound is positioned beneath the first component region EA1 and the second component region EA2.

A plurality of light-emitting diodes and a plurality of pixel circuits for generating and transmitting a light-emitting current to each of the plurality of light-emitting diodes may be positioned in the display region DA. Here, one light-emitting diode and one pixel circuit are referred to as a pixel PX. The display region DA has one pixel circuit and one light-emitting diode formed in a one-to-one correspondence.

The first component region EA1 may include a region composed of a transparent layer that allows light to penetrate, in which a conductive layer or a semiconductor layer is not positioned. The first component region EA1 may include a transmitting region having a structure that does not block light by including a pixel-defining layer comprising a light-blocking material or the like with openings that overlap with positions corresponding to the first component region EA1 and a display region including a plurality of pixels.

The second component region EA2 may include a transmitting region through which light and/or sound may be transmitted and a display region including a plurality of pixels. The transmission portion may include a transparent layer positioned between adjacent pixels and through which light and/or sound may be transmitted.

The display region of the first component region EA1 and the second component region EA2 includes one unit structure composed of a plurality of pixels, and a transmitting region of the first component region EA1 and the second component region EA2 may be positioned between the adjacent unit structures.

Referring to FIG. 1, FIG. 2, and FIG. 3, the display panel DP may include a display region DA including a display pixel and a touch sensor TS. The display panel DP may include a pixel that is a component for generating an image, and may be visible to a user from the outside through the transmitting region TA. In addition, the touch sensor TS may be positioned above the pixel, and may detect an external input applied from the outside. The touch sensor TS may detect an external input provided to the cover window WU.

Referring back to FIG. 2, the second peripheral region PA2 may include a bending unit. The display region DA and the first peripheral region PA1 may have a flat state in a state substantially parallel to a plane defined by the first and second directions DR1 and DR2, and one side of the second peripheral region PA2 may extend from a flat state, and may have a flat state again after passing through the bending unit. As a result, at least a portion of the second peripheral region PA2 may be bent to be assembled to be positioned on the rear surface of the display region DA. When at least a portion of the second peripheral region PA2 is assembled, because it overlaps the display region DA on a plane, the blocking region BA of the display device 1000 may be reduced. However, the present disclosure is not limited thereto. For example, the second peripheral region PA2 may not be bent.

The driver 50 may be mounted on the second peripheral region PA2, and may be mounted on the bending unit, or may be positioned on one of both sides of the bending unit. The driver 50 may be provided in the form of a chip.

The driver 50 may be electrically connected to the display region DA to transmit an electrical signal to the display region DA. For example, the driver 50 may provide data signals to pixels PX located in the display region DA.

Alternatively, the driver 50 may include a touch driver (e.g., a touch-driving circuit), and may be electrically connected to the touch sensor TS located in the display region DA. Meanwhile, the driver 50 may include various circuits, or may be designed to provide various electrical signals to the display region DA in addition to the above-described circuits.

The display device 1000 may have a pad positioned at an end of the second peripheral region PA2, and may be electrically connected to a flexible printed circuit board (FPCB) including a driving chip by a pad.

Here, the driving chip positioned on the flexible printed circuit board may include various driving circuits for driving the display device 1000 or a connector for supplying power. According to one or more embodiments, instead of the flexible printed circuit board, a rigid printed circuit board (PCB) may be used.

The optical element ES may be located under the display panel DP. The optical element ES may include a first optical element ES1 overlapping the first component region EA1, and a second optical element ES2 overlapping the second component region EA2. That is, the first optical element ES1 may be positioned on the rear surface of the first component region EA1, and the second optical element ES2 may be positioned on the rear surface of the second component region EA2.

The first optical element ES1 may be at least one of a camera, an infrared camera, a dot projector, an infrared illuminator, or a time-of-flight sensor.

The second optical element ES2 may be an electronic element using light or sound. For example, the second optical element ES2 may be a sensor that receives and uses light, such as an infrared sensor, a sensor that measures a distance by outputting and detecting light or sound, a small lamp that outputs light, or a speaker that outputs sound. In the case of an electronic element using light, light of various wavelength bands, such as visible light, infrared light, and ultraviolet light may be used. However, this is merely an example, and the types of the first optical element ES1 and the second optical element ES2 may vary.

Referring to FIG. 3, the display device 1000 may include a display panel DP, a power supply module PM, a first electronic module EM1, and a second electronic module EM2. The display panel DP, the power supply module PM, the first electronic module EM1, and the second electronic module EM2 may be electrically connected to each other. In FIG. 3, by way of example, a display pixel and a touch sensor TS positioned in the display region DA among the components of the display panel DP are illustrated.

The power supply module PM may supply power required for the overall operation of the display device 1000. The power supply module PM may include a conventional battery module.

The first electronic module EM1 and the second electronic module EM2 may include various functional modules for operating the display device 1000. In one or more embodiments, the first electronic module EM1 may be directly mounted on a mother board electrically connected to the display panel DP or mounted on a separate substrate to be electrically connected to the mother board through a connector or the like.

The first electronic module EM1 may include a control module CM, a wireless communication module TM, an image input module IIM, an audio input module AIM, a memory MM, and an external interface IF. Some of the modules are not mounted on the mother board but may be electrically connected to the mother board through a flexible printed circuit board connected thereto.

The control module CM may control the overall operation of the display device 1000. The control module CM may be a microprocessor. For example, the control module CM activates or deactivates the display panel DP. The control module CM may control other modules, such as an image input module IIM or an audio input module AIM based on the touch signal received from the display panel DP.

The wireless communication module TM may transmit/receive wireless signals to/from other terminals using a Wi-Fi® module, or a Bluetooth® module (Wi-Fi® being a registered trademark of the non-profit Wi-Fi Alliance, and Bluetooth® being a registered trademark of Bluetooth Sig, Inc., Kirkland, WA). The wireless communication module TM may transmit/receive a voice signal using a general communication line. The wireless communication module TM includes a transmitter TM 1 that modulates and transmits a signal to be transmitted, and a receiver TM 2 that demodulates a received signal.

The image input module IIM may process an image signal and convert the image signal into image data that may be displayed on the display panel DP. The audio input module AIM may receive an external sound signal through a microphone in a recording mode, a voice recognition mode, and the like and convert the external sound signal into electrical voice data.

The external interface IF may serve as an interface connected to an external charger, a wired/wireless data port, and a card socket (e.g., a memory card, a SIM/UIM card).

The second electronic module EM2 may include an audio output module AOM, a light-emitting module LM, a light-receiving module LRM, a camera module CMM, and the like, and at least a part of the optical element ES may be positioned on the rear surface of the display panel DP as shown in FIGS. 1 and 2. The optical element ES may include a light-emitting module LM, a light-receiving module LRM, a camera module CMM, and the like. Additionally, the second electronic module EM2 may be mounted directly on the motherboard or may be mounted on a separate substrate, and may be electrically connected to the display panel DP through a connector, or may be electrically connected to the first electronic module EM1.

The audio output module AOM may convert sound data received from the wireless communication module TM or sound data stored in the memory MM and output the converted sound data to the outside.

The light-emitting module LM may generate and output light. The light-emitting module LM may output infrared ray. For example, the light-emitting module LM may include an LED element. For example, the light-receiving module LRM may detect infrared ray. The light-receiving module LRM may be activated when infrared ray of a corresponding level or higher are detected. The light-receiving module LRM may include a CMOS sensor. After the infrared light generated by the light-emitting module LM is output, it is reflected by an external subject (e.g., a user's finger or face), and the reflected infrared light may be incident on the light-receiving module LRM. The camera module CMM may capture an external image.

In one or more embodiments, the optical element ES may additionally include a light sensor or a heat sensor. The optical element ES may sense an external subject received through the front surface or may provide a sound signal, such as voice, to the outside through the front surface thereof. In addition, the optical element ES may include a plurality of components but is not limited to any embodiments.

Referring back to FIG. 2, the housing HM may be coupled to the cover window WU. The cover window WU may be located on the front surface of the housing HM. The housing HM may be coupled to the cover window WU to provide an accommodation space. The display panel DP and the optical element ES may be accommodated in a corresponding space provided between the housing HM and the cover window WU.

The housing HM may include a material having relatively high rigidity. For example, the housing HM may include a plurality of frames and/or plates composed of glass, plastic, or metal, or a combination thereof. The housing HM may stably protect components of the display device 1000 accommodated in the inner space from external impact.

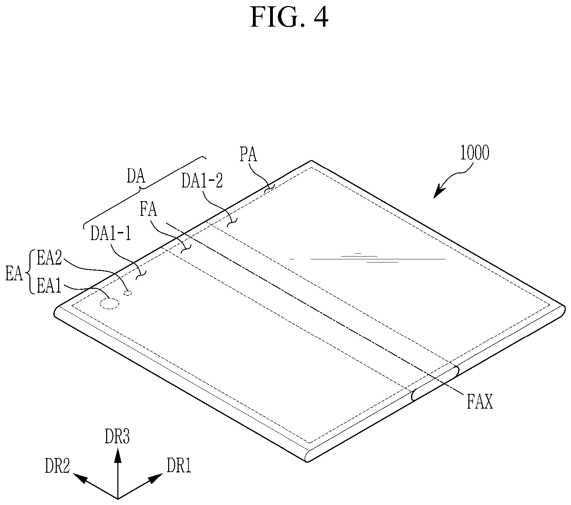

Hereinafter, the structure of the display device 1000 according to some embodiments will be described with reference to FIG. 4. FIG. 4 is a perspective view illustrating a display device according to some embodiments. Descriptions of the same configuration as the above-described components will be omitted.

In one or more embodiments of FIG. 4, a foldable display device having a structure in which the display device 1000 is folded through the folding axis FAX is illustrated.

Referring to FIG. 4, in one or more embodiments, the display device 1000 may be a foldable display device. The display device 1000 may be folded outward or inward with respect to the folding axis FAX. When the folding axis FAX is folded outward, the display surface of the display device 1000 is positioned outward in the third direction DR3, respectively, so that an image may be displayed in both directions. When the folding axis FAX is folded inward, the display surface may not be visually recognized from the outside.

In one or more embodiments, the display device 1000 may include a display region DA, a component region EA, and a non-display region PA. The display region DA may include a first-first display region DA1-1, a first-second display region DA1-2, and a folding region FA. The first-first display region DA1-1 and the first-second display region DA1-2 may be positioned on the left and right sides, respectively, with respect to the folding axis FAX, and the folding region FA may be positioned between the first-first display region DA1-1 and the first-second display region DA1-2.

Here, when folded outward based on the folding axis FAX, the first-first display region DA1-1 and the first-second display region DA1-2 are respectively positioned on both sides in the third direction DR3, and images may be displayed in both directions. Additionally, when folded inward based on the folding axis FAX, the first-first display region DA1-1 and the first-second display region DA1-2 may not be visible from the outside.

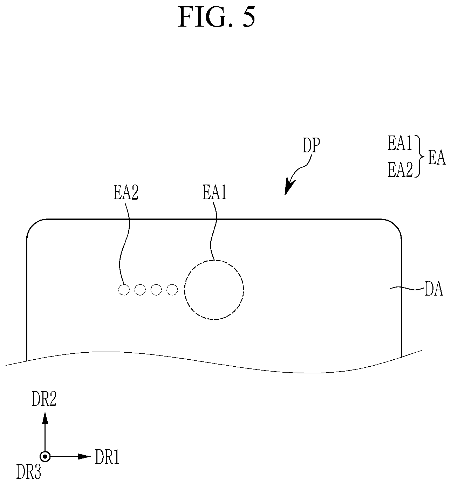

FIG. 5 is an enlarged plan view illustrating a partial region of a display device according to one or more embodiments.

In FIG. 5, a portion of a display panel DP is illustrated in a display device according to one or more embodiments and is illustrated using a display panel for a mobile phone.

The display panel DP has a display region DA positioned on the front surface and may include a component region EA on the front surface, for example, a first component region EA1 and a second component region EA2. Additionally, in the one or more embodiments corresponding to FIG. 5, the first component region EA1 is positioned at a position adjacent to the second component region EA2. In one or more embodiments of FIG. 5, the second component region EA2 may be positioned on the left side of the first component region EA1. The position and number of the first component regions EA1 are not limited thereto, and may be variously changed according to embodiments. In FIG. 5, the optical element corresponding to the first component region EA1 may be a camera, and the optical element corresponding to the second component region EA2 may be an optical sensor. For example, the optical element positioned in the first component region EA1 may be an infrared camera, and the optical element corresponding to the second component region EA2 may be an infrared optical sensor. However, this is merely an example, and the present disclosure is not limited thereto, and may be variously changed.

In the display region DA, a plurality of light-emitting diodes and a plurality of pixel circuits for generating and transmitting a light-emitting current to each of the plurality of light-emitting diodes are formed. Here, one light-emitting diode and one pixel circuit are referred to as a pixel PX.

One light-emitting diode may be positioned in the display region DA to correspond to one pixel circuit. The display region DA is also referred to as a normal display region. With respect to the structure of the display panel DP under the cutting line, the display region DA may be positioned under the cutting line.

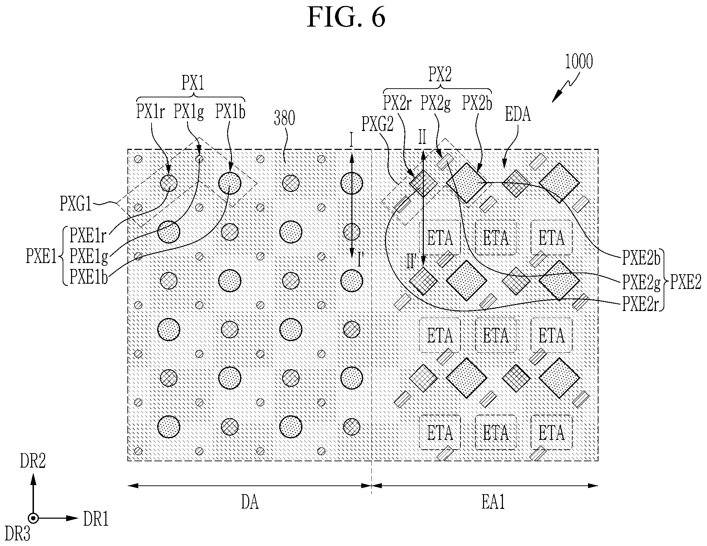

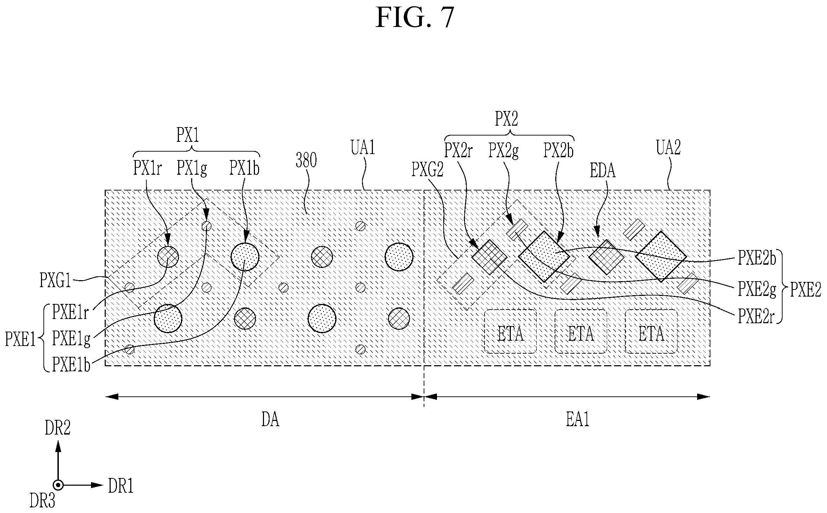

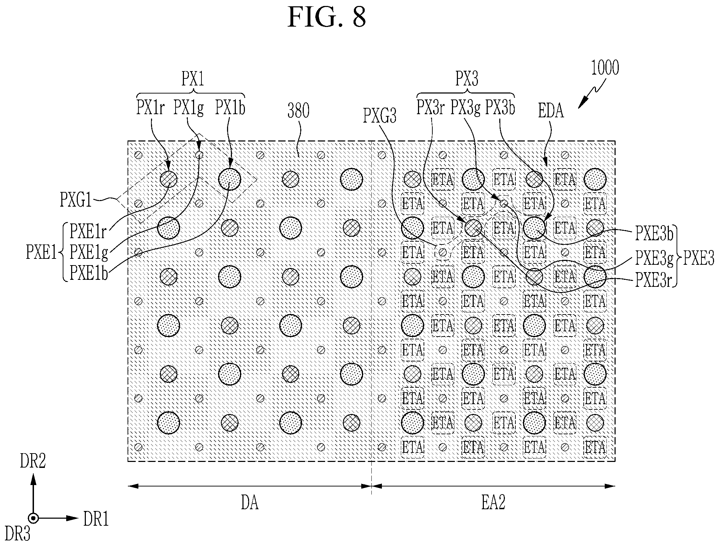

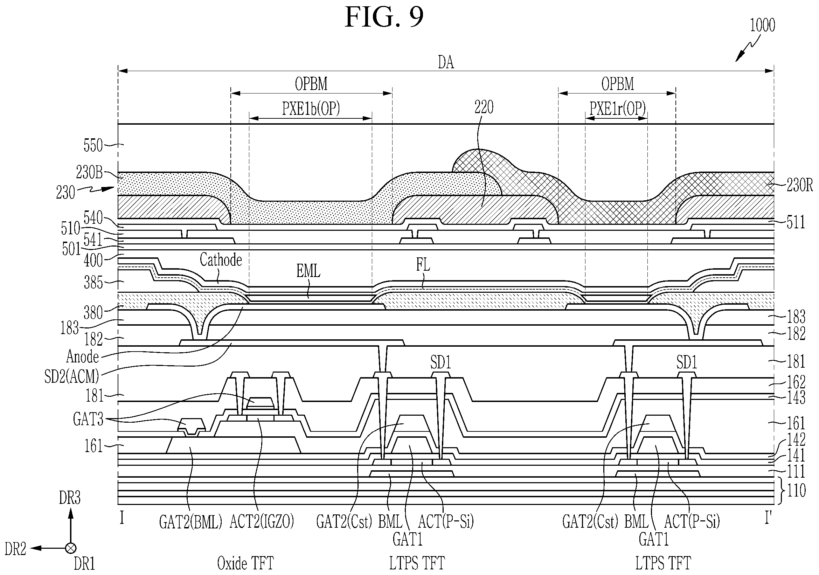

The light-transmitting region (see ETA in FIG. 6 and ETA in FIG. 7) positioned in the lower panel layer of the first component region EA1 and the second component region EA2 is composed only of a transparent layer that allows light to transmit therethrough, and no conductive layer or semiconductor layer is positioned thereon. The pixel-defining layer (e.g., pixel-defining layer 380 in FIG. 9), the light-blocking member (e.g., light-blocking member 220 in FIG. 9), and the color filter layer (e.g., color filter layer 230 in FIG. 9) of the panel may have openings at positions corresponding to the first component region EA1 to allow light to pass through. Meanwhile, even if the light-transmitting region ETA is positioned in the lower panel layer among the first component region EA1 and the second component region EA2, a region without an opening corresponding to the upper panel layer may be a component display region EA2 (see EDA in FIGS. 6 and 8) of the first component region EA1 and the second component region.

The component display region EDA may have the same structure as the display region DA. However, this is an example, and the structure of the upper panel layer corresponding to the light-transmitting region ETA positioned in the lower panel layer of the first component region EA1 and the second component region EA2 may be variously changed according to the type of the optical element ES positioned corresponding to the first component region EA1 and the second component region EA2. For example, the pixel-defining layer 380, the light-blocking member 220, and the color filter layer 230 of the upper panel layer, which correspond to the light-transmitting region ETA of the first component region EA1 and the second component region EA2, do not include/define an opening at a position corresponding to the light-transmitting region ETA, and the pixel-defining layer 380, the light-blocking member 220, and the color filter layer 230 may cover the light-transmitting region ETA as a whole. A detailed explanation will be provided later.

The display panel DP may be broadly divided into a lower panel layer and an upper panel layer. The lower panel layer is the part where the light-emitting diode and pixel circuit constituting the pixel are positioned, and may include an encapsulation layer (e.g., encapsulation layer 400 in Fig. 9) that covers the pixel. That is, the lower panel layer includes an anode, a pixel-defining layer (e.g., pixel-defining layer 380 of FIG. 9), a light-emitting layer (e.g., light-emitting layer EML of FIG. 9), a functional layer (e.g., functional layer FL of FIG. 9), and a cathode (e.g., Cathode of FIG. 9) from the substrate (e.g., substrate 110 of FIG. 9) to the encapsulation layer, and may include an insulating film, a semiconductor layer, and a conductive layer between the substrate and the anode. Meanwhile, the upper panel layer is a portion positioned on the upper side of the encapsulation layer, and includes a sensing insulating layer capable of detecting touch (e.g., see 501, 510, 511 of FIG. 9) and a plurality of sensing electrodes (e.g., see 540, 541 of FIG. 9), and may include a light-blocking member (e.g., light-blocking member 220 of FIG. 9), a color filter layer (e.g., color filter layer 230 of FIG. 9), and a planarization layer (e.g., planarization layer 550 of FIG. 9).

In one or more embodiments, a peripheral region may be further positioned outside the display region DA. In addition, although FIG. 5 illustrates a display panel for a mobile phone, the embodiments may be applied to a display panel in which an optical element may be positioned on the rear surface of the display panel, or may be a flexible display device. In the case of a foldable display device among flexible display devices, the positions of the first component region EA1 and the second component region EA2 may be positioned at positions different from those of FIG. 5.

Hereinafter, the display region DA and the component region EA will be described in detail with reference to FIGS. 6 to 8.

FIG. 6 is an enlarged plan view illustrating a display region and a first component region of a display device according to one or more embodiments. FIG. 7 is a plan view illustrating a partial region of FIG. 5. FIG. 8 is an enlarged plan view illustrating a display region and a second component region according to one or more embodiments.

Referring to FIG. 6, the display region DA may include a plurality of first pixels PX1, and the first component region EA1 may include a plurality of second pixels PX2 and a plurality of light-transmitting regions ETA positioned in the component display region EDA.

A plurality of second pixels PX2 may be positioned in the component display region EDA of the first component regions EA1. The first component region EA1 may include a plurality of light-transmitting regions ETA. The light-transmitting region ETA may be a region through which light output from the first optical element ES1 positioned on the rear surface of the display panel (e.g., DP of FIG. 2) is transmitted.

The light-transmitting region ETA may include a partial region through which light cannot be transmitted as it overlaps a configuration positioned in the upper panel layer. For example, as illustrated in FIG. 6, a region overlapping the second pixel PX2 in the light-transmitting region ETA corresponds to a region where light cannot transmit, and this region may correspond to the component display region EDA.

The plurality of light-transmitting regions ETA are positioned in the lower panel layer, and may be defined by a plurality of signal lines and/or metal blocking patterns, such as gate lines and data lines for transmitting signals to the plurality of second pixels PX2, positioned in the component display region EDA. That is, a boundary line of the light-transmitting region ETA is formed by a plurality of signal lines crossing and extending from each other, and a plurality of light-transmitting regions ETA may be surrounded by a plurality of signal lines.

A plurality of light-transmitting region ETA may be positioned adjacent to the component display region EDA. For example, a plurality of light-transmitting regions ETA may be positioned between the component display regions EDA. In FIG. 6, the areas or sizes of the plurality of light-transmitting regions ETA are illustrated as being substantially the same, but the present disclosure is not limited thereto and may be variously changed. For example, some of the plurality of light-transmitting regions ETA may have different shapes and/or sizes in plan view with other portions.

In addition, in one or more embodiments, the first component region EA1 may further include a fine light-transmitting region having an area that is smaller than area of the light-transmitting region ETA. For example, the fine light-transmitting region may be positioned between a plurality of second pixels PX2 positioned in the component display region EDA.

Unlike the display region DA, as the first component region EA1 includes a plurality of light-transmitting regions ETA through which light is transmitted, the transmittance of the first component region EA1 may be greater than transmittance of the display region DA.

Although the light-transmitting region ETA included in the first component region EA1 has been described, the description thereof may be substantially the same to the light-transmitting region ETA included in the second component region EA2.

A plurality of first pixels PX1 positioned in the display region DA may include a first-first pixel PX1r, a first-second pixel PX1g, and a first-third pixel PX1b. A plurality of second pixels PX2 positioned in the first component region EA1 may include a second-first pixel PX2r, a second-second pixel PX2g, and a second-third pixel PX2b.

In one or more embodiments, the first-first pixel PX1r and the second-first pixel PX2r may be red pixels for emitting red light, the first-second pixel PX1g and the second-second pixel PX2g may be green pixels for emitting green light, and the first-third pixel PX1b and the second-third pixel PX2b may be blue pixels for emitting blue light. However, this is an example, and the colors of light emitted by the first pixel PX1 and the second pixel PX2 may be variously changed.

In one or more embodiments, the first pixels PX1 may constitute a first pixel group PXG1, and the second pixels PX2 may constitute one second pixel group PXG2.

In detail, the first pixel group PXG1 may include four first pixels PX1. The four first pixels PX1 constituting one first pixel group PXG1 may be one first-first pixel PX1r, two first-second pixels PX1g, and one first-third pixel PX1b.

Three first pixels PX1 of the four first pixels PX1 of one first pixel group PXG1 may be arranged in parallel along one diagonal direction crossing the first direction DR 1 and the second direction DR 2, and the other one first pixel PX1 may be spaced apart from the first pixel PX1 positioned in the middle of the three first pixels PX1 positioned along one diagonal direction. For example, one first-first pixel PX1r and two first-second pixels PX1g included in any one of the first pixel groups PXG1 may be alternately arranged along one diagonal direction, and the first-first pixel PX1r positioned between the two first-second pixels PX1g may be spaced apart from the first-third pixel PX1b in the first direction DR1.

In addition, one first-third pixel PX1b and two first-second pixels PX1g included in the other one of the first pixel groups PXG1 may be alternately arranged along one diagonal direction, and the first-third pixel PX1b positioned between the two first-second pixels PX1g may be spaced apart from the first-first pixel PX1r in the first direction DR1. However, this is an example, and the number, type, and arrangement of pixels constituting the first pixel group PXG1 may be variously changed.

The second pixel group PXG2 may include four second pixels PX2. The four second pixels PX2 constituting one second pixel group PXG2 may be one second-first pixel PX2r, two second-second pixel PX2g, and one second-third pixel PX2b. Among the four second pixels PX2 constituting one second pixel group PXG2, three second pixels PX2 are arranged parallel to one side diagonal direction crossing the first direction DR1 and the second direction DR2, and the remaining one second pixel PX2 may be spaced apart from the second pixel PX2 positioned in the middle along the first direction DR1 among the three second pixels PX2 arranged along the one side diagonal direction. For example, one second-first pixel PX2r and two second-second pixels PX2g included in the second pixel group PXG2 may be alternately arranged along one diagonal direction, and the second-first pixel PX2r positioned between the two second-second pixels PX2g may be spaced apart from the second-third pixel PX2b in the first direction DR1. However, this is an example, and the number, type, and arrangement of pixels constituting the second pixel group PXG2 may be variously changed.

In one or more embodiments, a plurality of first pixel groups PXG1 may be repeatedly arranged in a first direction DR1 and a second direction DR2 in the display region DA. The plurality of second pixel groups PXG2 may be arranged in parallel along the first direction DR1 in the component display region EDA, and may be arranged to be spaced apart from each other in the second direction DR2 by interposing the light-transmitting region ETA therebetween.

The arrangement of the first pixels PX1 arranged in the display region DA and the second pixels PX2 arranged in the first component region EA1 on a plane may be different.

For example, as a plurality of first pixel groups PXG1 are repeatedly arranged in the display region DA, a plurality of first-second pixels PX1g are arranged in the first row in the first direction DR1, a first-first pixel PX1r and a first-third pixel PX1b are alternately arranged in the second row adjacent to the first row, a plurality of first-second pixels PX1g are arranged in the third row adjacent to the second row, and a first-first pixel PX1r and a first-third pixel PX1b may be alternately arranged in the third row and the fourth row. The arrangement of the first pixels PX1 may be repeated up to N rows. In addition, a plurality of first-second pixels PX1g arranged in the first row, a plurality of first-first pixels PX1r and a plurality of first-third pixels PX1b arranged alternately in the second row may be arranged alternately with each other.

Accordingly, a plurality of first-second pixels PX1g are arranged in a first column along the second direction DR2, first-first pixels PX1r and first-third pixel PX1b are arranged alternately in a second column adjacent to the first column, a plurality of first-second pixels PX1g are arranged in a third column adjacent to the second column, and first-first pixels PX1r and first-third pixels PX1b are arranged alternately in a fourth column adjacent to the third column, and this arrangement can be repeated up to an M-th column.

As the first component region EA1 includes a plurality of light-transmitting regions ETA, the planar arrangement of the plurality of second pixels PX2 arranged in the first component region EA1 may be different from the planar arrangement of the plurality of first pixels PX1 arranged in the display region DA.

For example, some of the plurality of second pixel groups PXG2 may be positioned spaced apart from each other in the second direction DR2 with the light-transmitting region ETA interposed therebetween. In the plurality of component display regions EDA, a plurality of second-second pixels PX2g may be arranged in the first row, a second-first pixel PX2r and a second-third pixel PX2b may be alternately arranged in the second row adjacent to the first row, and a plurality of first-second pixels PX1g may be arranged in the third row adjacent to the second row. In addition, a plurality of second-second pixels PX2g arranged in the first row and a plurality of second-first pixels PX2r and second-third pixels PX2b arranged alternately in the second row may be arranged alternately with each other.

A plurality of second pixels PX2 may be positioned spaced apart in the second direction DR2 with a plurality of light-transmitting regions ETA therebetween. However, this is an example, and the planar arrangement shape of a plurality of second pixels PX2 positioned in the first component region EA1 is not limited thereto and may be changed in various ways.

In one or more embodiments, the plurality of light-transmitting regions ETA may overlap a portion of the plurality of second pixels PX2. For example, the plurality of light-transmitting regions ETA may overlap a portion of the plurality of second-second pixels PX2g positioned at one side in the second direction DR2. For example, the plurality of light-transmitting regions ETA may overlap a portion of each of the second-second pixels PX2g positioned in the first row of the component display region EDA. However, the present disclosure is not limited thereto, and the plurality of light-transmitting regions ETA may be formed so as not to overlap the second pixel PX2.

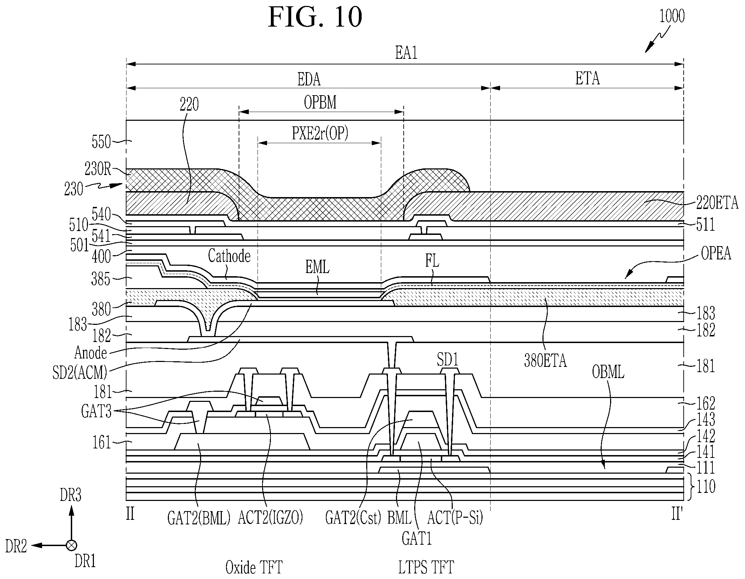

A planar shape of each of the first pixels PX1 and the second pixels PX2 may correspond to a shape of a light-emitting region. The light-emitting region may be a region defined by an opening (e.g., opening OP of FIGS. 9 and 10) defined by the pixel-defining layer 380. A region of the pixel-defining layer 380 positioned around the light-emitting region may be a non-emission region.

The display region DA may include a plurality of first light-emitting regions PXE1 corresponding to a plurality of first pixels PX1 and a non-emission region surrounding them, and the component display region EDA of the first component region EA1 may include a plurality of second light-emitting regions PXE2 corresponding to a plurality of second pixels PX2 and a non-emission region surrounding them

In one or more embodiments, a plurality of first light-emitting regions PXE1 positioned in the display region DA and a plurality of second light-emitting regions PXE2 positioned in the component display region EDA of the first component region EA1 may have different sizes or areas, and the shapes of the first light-emitting regions PXE1 and the second light-emitting regions PXE2 may be different.

For example, the first light-emitting regions PXE1 may include a first-first light-emitting region PXE1r corresponding to the first-first pixel PX1r, a first-second light-emitting region PXE1g corresponding to the first-second pixel PX1g, and a first-third light-emitting region PXE1b corresponding to the first-third pixel PX1b.

The first-first light-emitting region PXE1r may have different sizes or areas from the first-second light-emitting region PXE1g and the first-third light-emitting region PXE1b. For example, the size of the first-third light-emitting region PXE1b may be larger than the sizes of the first-first light-emitting region PXE1r and the first-second light-emitting region PXE1g. The size of the first-first light-emitting region PXE1r may be larger than the size of the first-second light-emitting region PXE1g. That is, the first-third light-emitting region PXE1b may have the largest size, and the first-second light-emitting region PXE1g may have the smallest size. However, this is an example, and the sizes of the first light-emitting regions PXE1 may be variously changed.

Each of the first light-emitting regions PXE1 may have a curved planar shape including an elliptical or circular shape in a plan view. However, the planar shape of the first light-emitting region PXE1 is not limited thereto and may be

**EP 4 686 357 A1**

variously changed. For example, the first light-emitting region PXE1 may have a polygonal shape, an elliptical shape, or a shape in which each side is curved.

The second light-emitting regions PXE2 may include a second-first light-emitting region PXE2r corresponding to the second-first pixel PX2r, a second-second light-emitting region PXE2g corresponding to the second-second pixel PX2g, and a second-third light-emitting region PXE2b corresponding to the second-third pixel PX2b.

The second-first light-emitting region PXE2r may have different sizes or areas in the second-second light-emitting region PXE2g and the second-third light-emitting region PXE2b. For example, the size of the second-third light-emitting region PXE2b may be larger than the sizes of the second-first light-emitting region PXE2r and the second-second light-emitting region PXE2g. The size of the second-first light-emitting region PXE2r may be larger than the size of the second-second light-emitting region PXE2g. That is, the second-third light-emitting region PXE2b may have the largest size, and the second-second light-emitting region PXE2g may have the smallest size. However, this is an example, and the sizes of the second light-emitting regions PXE2 may be variously changed.

The second light-emitting region PXE2 may have a polygonal shape including a square in a plan view. For example, the second light-emitting region PXE2 may have a rectangular shape in a plan view. However, the shape of the second light-emitting region PXE2 in a plan view is not limited thereto, and may be variously changed. For example, the second light-emitting region PXE2 may have a curved planar shape including an elliptical or circular shape in a plan view.

In one or more embodiments, an area in a plan view of each of the plurality of first light-emitting regions PXE1 positioned in the display region DA may be different from an area in a plan view of each of the plurality of second light-emitting regions PXE2 positioned in the first component region EA1. For example, an area of each of the first light-emitting regions PXE1 in a plan view may be smaller than an area in a plan view of each of the plurality of second light-emitting regions PXE2. The first light-emitting region PXE1 and the second light-emitting region PXE2 may have different area when comparing light-emitting regions emitting the same color.

For example, an area of the first-first light-emitting region PXE1r emitting the same color may be different from an area of the second-first light-emitting region PXE2r, an area of the first-second light-emitting region PXE1g may be different from an area of the second-second light-emitting region PXE2g, and an area of the first-third light-emitting region PXE1b may be different from an area of the second-third light-emitting region PXE2b. For example, an area of the first-first light-emitting region PXE1r may be smaller than an area of the second-first light-emitting region PXE2r, an area of the first-second light-emitting region PXE1g may be smaller than an area of the second-second light-emitting region PXE2g, and an area of the first-third light-emitting region PXE1b may be smaller than an area of the second-third light-emitting region PXE2b. However, this is an example, and the area relationship between the first light-emitting region PXE1 and the second light-emitting region PXE2 may be variously changed.

Referring to FIG. 7, in one or more embodiments, an aperture ratio of the display area DA may be different from an aperture ratio of the first component area EA1. Here, the aperture ratio may mean aperture ratios of a plurality of first light-emitting regions PXE1 positioned in the display area DA, and aperture ratios of a plurality of second light-emitting regions PXE2 positioned in the first component area EA1.

Referring to FIG. 7, in one or more embodiments, an aperture ratio of a plurality of first light-emitting regions PXE1 positioned within the first unit area UA1 of the display area DA may be different from an aperture ratio of a plurality of second light-emitting regions PXE2 positioned within the second unit area UA2 of the first component area EA1.

Here, the first unit area UA1 and the second unit area UA2 have substantially the same area, and the aperture ratio may mean a relative (surface) area between the first light-emitting region PXE1 and the second light-emitting region PXE2. That is, the aperture ratio may refer to the ratio of the (surface) area occupied by the first light-emitting region PXE1 defined by the opening of the pixel-defining layer 380 (e.g., opening OP of FIG. 9) in the first unit area UA1, and the area occupied by the second light-emitting region PXE2 defined by the opening of the pixel-defining layer 380 in the second unit area UA2.

As described above, because the sizes of the plurality of first light-emitting regions PXE1 having different areas are smaller than respective areas of the plurality of second light-emitting regions PXE2 having different areas, the aperture ratio of the first light-emitting region PXE1 may be less than aperture ratio of the second light-emitting region PXE2.

For example, the size of the first-first light-emitting region PXE1r emitting the same color is smaller than the size of the second-first light-emitting region PX2r, the size of the first-second light-emitting region PXE1g is smaller than the size of the second-second light-emitting region PX2g, and the size of the first-third light-emitting region PXE1b is smaller than the size of the second-third light-emitting region PX2b. Thus, the aperture ratio of the first light-emitting region PXE1 positioned in the display area DA may be less than the aperture ratio of the second light-emitting region PXE2 positioned in the first component region EA1. However, this is an example, and the relationship of the aperture ratio between the first light-emitting region PXE1 positioned in the display area DA and the second light-emitting region PXE2 positioned in the first component region EA1 may be variously changed.

In one or more embodiments, because the first component region EA1 has a plurality of light-transmitting regions ETA unlike the display region DA, the resolution of the display region DA and the first component region EA1 may be different. That is, the number of first pixels PX1 positioned in the display region DA may be different from the number of second pixels PX2 positioned in the first component region EA1. For example, the resolution of the display region DA may be greater than the resolution of the first component region EA1. That is, the number of first pixels PX1 positioned in the display region DA may be greater than the number of second pixels PX2 positioned in the first component region EA1. However, this is an example, and the resolution of the display region DA and the first component region EA1 or the relationship between the number of pixels PX1 and PX2 may be variously changed.

Here, the resolution may mean the resolution of the display region DA and the resolution of the first component region EA1 measured based on the same area. That is, it may mean a resolution measured based on each of the first unit area UA1 of the display region DA and the second unit area UA2 of the first component region EA1. In addition, the number of first pixels PX1 included in the display region DA and the number of second pixels PX2 positioned in the first component region EA1 may respectively mean the number of first pixels PX1 positioned within the first unit area UA1 and the number of second pixels PX2 positioned within the second unit area UA2.

In one or more embodiments, a Z value expressed by the following (Equation 1) regarding the relationship between the aperture ratio and resolution of each of the display region DA and the first component region EA1 may be greater than about 0.5 and less than or equal to about 1.

### Equation 1

$$Z = \left(\frac{X0}{X1}\right) * \left(\frac{Y0}{Y1}\right)$$

In Equation 1, X0 may mean the aperture ratio of a plurality of first light-emitting regions PXE1 positioned in the display region DA, and X1 may mean the aperture ratio of a plurality of second light-emitting regions PXE2 positioned in the first component region EA1.

Here, the aperture ratio of each of the plurality of first light-emitting regions PXE1 and the plurality of second light-emitting regions PXE2 may mean an aperture ratio measured based on the same area in each of the display region DA and the first component region EA1. In addition, a plurality of first light-emitting regions PXE1 may include a first-first light-emitting region PXE1r, a first-second light-emitting region PXE1g, and a first-third light-emitting region PXE1b, and a plurality of second light-emitting regions PXE2 may include a second-first light-emitting region PXE2r, a second-second light-emitting region PXE2g, and a second-third light-emitting region PXE2b.

Y0 may mean the resolution of the first component region EA1, and Y1 may mean the resolution of the display region DA.

In here, the resolution of each of the display region DA and the first component region EA1 may mean a resolution measured based on the same area in each of the display region DA and the first component region EA1. That is, the resolution of each of the display region DA and the first component region EA1 may respectively mean the number of a plurality of first pixels PX1 (or light-emitting layers EML, respectively) positioned in the display region DA and the number of second pixels PX2 (or light-emitting layers EML, respectively) positioned in the first component region EA1 based on the same area.

The Z value represented by Equation 1 regarding the relationship between the aperture ratio and resolution of each of the display region DA and the first component region EA1 may respectively mean a total area ratio of the first light-emitting region PXE1 positioned in the display region DA and a total area ratio of the second light-emitting region PXE2 positioned in the first component region EA1 based on the same area. That is, in Equation 1, the value X0*Y0 based on the same area may mean the total area of the first light-emitting region PXE1 positioned in the display region DA, and the value X1*Y1 may mean the total area of the second light-emitting region PXE2 positioned in the first component region EA1.

When the Z value expressed in Equation 1 regarding the relationship between the aperture ratio and resolution of each of the display region DA and the first component region EA1 satisfies the numerical range, as described above, pixels positioned in the display region DA and the first component region EA1 may have similar or substantially equal luminance and lifetime while maintaining the light transmittance of the first component region EA1 including the plurality of light-transmitting regions ETA.

When the Z value is greater than about 0.5 and less than about 1, the luminance deviation between the display region DA and the first component region EA1 decreases, and thus the compensation current or compensation voltage applied to the second pixel PX2 to compensate for the luminance deviation may decrease.

Accordingly, it is possible to reduce or prevent damage to the second pixel PX2 positioned in the first component region EA1 due to the compensation current or the compensation voltage.

In addition, when the Z value is about 1, as the luminance of the display region DA and the first component region EA1 become the same, a compensation current or compensation voltage to compensate for luminance deviation may not be applied to the second pixel PX2. Accordingly, it is possible to reduce or prevent damage to the second pixel PX2 positioned in the first component region EA1.

Referring to FIG. 8, the second component region EA2 may include a plurality of third pixels PX3 and a plurality of light-transmitting regions ETA. A plurality of third pixels PX3 positioned in the second component region EA2 may constitute one third pixel group PXG3.

For example, the third pixel group PXG3 may include four third pixels PX3. The four third pixels PX3 constituting one third pixel group PXG3 may be one third-first pixel PX3r, two third-second pixels PX3g, and one third-third pixel PX3b.

Here, the third-first pixel PX3r may be a red pixel that emits red light, the third-second pixel PX3g may be a green pixel that emits green light, and the third-third pixel PX3b may be a blue pixel that emits blue light. However, this is an example, and the color of light emitted by the third pixel PX3 may be variously changed.

In one or more embodiments, a plurality of third pixel groups PXG3 may be arranged in the second component region EA2. The plurality of third pixel groups PXG3 arranged in the second component region EA2 may have substantially the same planar arrangement as the plurality of first pixel groups PXG1 arranged in the display region DA. That is, the planar arrangement shape of the plurality of third pixels PX3 arranged in the second component region EA2 may be substantially the same as the planar arrangement shape of the plurality of first pixels PX1 arranged in the display region DA.

In one or more embodiments, the plurality of light-transmitting regions ETA positioned in the second component region EA2 may not overlap the plurality of third pixels PX3 positioned in the component display region EDA of the second component region EA2. That is, because the area of each of the plurality of light-transmitting regions ETA positioned in the second component region EA2 is smaller than the area of each of the plurality of light-transmitting regions ETA positioned in the first component region EA1, it may not overlap the third pixel PX3. However, the present disclosure is not limited thereto, and according to one or more embodiments, at least some of the plurality of light-transmitting regions ETA positioned in the second component region EA2 may overlap the third pixel PX3.

The second component region EA2 may include a component display region EDA and a non-emission region surrounding the component display region EDA. The component display region EDA may include a plurality of third light-emitting regions PXE3 corresponding to a plurality of third pixels PX3. That is, a plurality of third light-emitting regions PXE3 may be defined by an opening of the pixel-defining layer 380 (e.g., opening OP of FIG. 9).

The third light-emitting regions PXE3 may include a third-first light-emitting region PXE3r corresponding to the third-first pixel PX3r, a third-second light-emitting region PXE3g corresponding to the third-second pixel PX3g, and a third-third light-emitting region PXE3b corresponding to the third-third pixel PX3b.

The third-first light-emitting region PXE3r may have different sizes or areas from the third-second light-emitting region PXE3g and the third-third light-emitting region PXE3b. For example, the size of the third-third light-emitting region PXE3b may be larger than the sizes of the third-first light-emitting region PXE3r and the third-second light-emitting region PXE3g. The size of the third-first light-emitting region PXE3r may be larger than the size of the third-second light-emitting region PXE3g. That is, the size of the third-third light-emitting region PXE3b may be the largest, and the size of the third-second light-emitting region PXE3g may be the smallest. However, this is an example, and the sizes of the third light-emitting regions PXE3 may be variously changed.

In one or more embodiments, the size or area of a plurality of first light-emitting regions PXE1 positioned in a display region DA and a plurality of third light-emitting regions PXE3 positioned in a second component region EA2 may be substantially the same, and the planar shape of the first light-emitting region PXE1 and the planar shape of the third light-emitting region PXE3 may be substantially the same.

For example, the first light-emitting region PXE1 and the third light-emitting region PXE3 may have substantially the same area when comparing light-emitting region emitting the same color. That is, the first-first light-emitting region PXE1r may have substantially the same area as the third-first light-emitting region PXE3r, the first-second light-emitting region PXE1g may have substantially the same area as the third-second light-emitting region PXE3g, and the first-third light-emitting region PXE1b may have substantially the same area as the third-third light-emitting region PXE3b.

Also, in one configuration, each of the plurality of third light-emitting regions PXE3 positioned in the second component region EA2 may have substantially the same planar shape as the plurality of first light-emitting regions PXE1 positioned in the display region DA. For example, the third light-emitting region PXE3 may have a curved planar shape including an elliptical or circular shape in a plan view.

In one or more embodiments, the resolution of the display region DA and the resolution of the second component region EA2 may be substantially the same based on the same area. In addition, the aperture ratio of the first light-emitting region PXE1 positioned in the display region DA based on the same area may be substantially the same as aperture ratio of the third light-emitting region PXE3 positioned in the second component region EA2. However, this is an example, and depending on the configuration, the first light-emitting region PXE1 and the third light-emitting region PXE3 may have different areas and/or different planar shapes, and the resolution and/or aperture ratio of the display region DA and the second component region EA2 may be different.

In one or more embodiments, the second component region EA2 may include a plurality of light-transmitting regions ETA. The arrangement, density, and size of the plurality of light-transmitting regions ETA positioned in the second component region EA2 may be different from the arrangement, number, and size of the plurality of light-transmitting regions ETA positioned in the first component region EA1.

This may be a result of different types of the first optical element (e.g., ES1 in FIG. 2) positioned to correspond to the first component region EA1, and the second optical element (e.g., ES2 in FIG. 2) positioned to correspond to the second component region EA2. That is, as the types of the first optical element ES1 and the second optical element ES2 are different, at least one of the arrangement, density, or size of the light-transmitting region ETA positioned in the first component region EA1 and the second component region EA2 corresponding to each of the first optical element ES1 and the second optical element ES2 may be different.

For example, a plurality of light-transmitting regions ETA positioned in the second component region EA2 may be repeatedly arranged along the first and second directions DR1 and DR2. A plurality of light-transmitting regions ETA may be positioned between a plurality of third pixels PX3. For example, a third-first pixel PX3r and a third-third pixel PX3b may be respectively positioned on both sides of the light-transmitting region ETA in the first direction DR1, and a third-second pixel PX3g may be positioned on both sides in the second direction DR2.

The area of the light-transmitting region ETA positioned in the second component region EA2 may be smaller than the area of the light-transmitting region ETA positioned in the first component region EA1, and the number of light-transmitting regions ETA positioned in the second component region EA2 may be greater than the number of light-transmitting regions ETA positioned in the first component region EA1. That is, the density of the light-transmitting region ETA positioned in the component region EA2 based on the same area may be greater than the density of the light-transmitting region ETA positioned in the first component region EA1. However, this is example, and the arrangement, density, and size of the plurality of light-transmitting regions ETA positioned in the second component region EA2 may be variously changed.

Hereinafter, a stacked structure of the display region DA and the first component region EA1 will be described with reference to FIGS. 9 and 10.

FIG. 9 is a cross-sectional view taken along the line I-I' of FIG. 6. FIG. 10 is a cross-sectional view taken along the line II-II' of FIG. 6.

Referring to FIGS. 9 and 10, a metal layer BML may be positioned on the substrate 110.

The substrate 110 may include a material that has rigid characteristics, such as glass and thus does not bend or may include a flexible material that may be bent, such as plastic or polyimide. In the case of a flexible substrate, as shown in FIGS. 9 and 10, a polyimide and a two-layer structure of a barrier layer formed of an inorganic insulating material may be double-formed.

The metal layer BML may include an opening OBML. The opening OBML of the metal layer BML may correspond to the light-transmitting region ETA. That is, the metal layer BML might not overlap the light-transmitting region ETA (e.g., might be separated from the light-transmitting region ETA in plan view), the light-transmitting region ETA being positioned in the first component region EA1. The opening OBML of the metal layer BML may serve as a mask for forming a pattern corresponding to the light-transmitting region ETA in a subsequent process. In one or more embodiments, the metal layer BML may be omitted.

The metal layer BML, also referred to as a lower shielding layer, may include a metal or a metal alloy, such as copper Cu, molybdenum Mo, aluminum Al, titanium Ti, and may additionally include amorphous silicon, and may be composed of a single layer or multiple layers.

A buffer layer 111 covering the substrate 110 and the metal layer BML may be positioned thereon. The buffer layer 111 serves to block the penetration of impurity elements into the first semiconductor layer ACT and may be an inorganic insulating layer including silicon oxide (SiOx), silicon nitride (SiNx), silicon oxynitride (SiONx), or the like.

A first semiconductor layer ACT formed of a silicon semiconductor (e.g., a polycrystalline semiconductor) may be positioned on the buffer layer 111. The first semiconductor layer ACT includes a channel of a driving transistor and has a region having a conductive layer characteristic on both sides of each channel by plasma treatment or doping, and thus may serve as a first electrode and a second electrode. The transistor including the first semiconductor layer ACT may be referred to as a polycrystalline semiconductor transistor, and the polycrystalline semiconductor transistor may be a p-type transistor.

A first gate-insulating layer 141 may be positioned on the first semiconductor layer ACT. The first gate-insulating layer 141 may be an inorganic insulating layer including silicon oxide (SiOx), silicon nitride (SiNx), silicon oxynitride (SiONx), or the like.

The first gate conductive layer GAT1 may be positioned on the first gate-insulating layer 141. The first gate conductive layer GAT1 may include a gate electrode of a driving transistor. The first gate conductive layer GAT1 may overlap the first semiconductor layer ACT.

The first gate conductive layer GAT1 may include a metal or a metal alloy, such as copper (Cu), molybdenum (Mo), aluminum (Al), titanium (Ti), and may be formed as a single layer or multiple layers.

The second gate-insulating layer 142 may be positioned on the first gate conductive layer GAT1 and the first gate-insulating layer 141. The second gate-insulating layer 142 may be an inorganic insulating layer including silicon oxide (SiOx), silicon nitride (SiNx), silicon oxynitride (SiONx), or the like.

The second gate-insulating layer 142 is positioned to overlap with the first gate conductive layer GAT1 to form and maintain the storage capacitor Cst, and a second gate conductive layer GAT2, which includes a metal layer BML positioned to overlap with the oxide semiconductor layer ACT2, may be positioned.

The second gate conductive layer GAT2 may include a metal or a metal alloy, such as copper Cu, molybdenum Mo, aluminum Al, titanium Ti, and may be formed as a single layer or multiple layers.

A first interlayer insulating layer 161 may be positioned on the second gate conductive layer GAT2. The first interlayer insulating layer 161 may include an inorganic insulating layer including silicon oxide SiOx, silicon nitride SiNx, silicon oxynitride SiONx, or the like, and may form a thick inorganic insulating material according to embodiments.

An oxide semiconductor layer ACT2 may be positioned on the first interlayer insulating layer 161. A transistor including the oxide semiconductor layer ACT2 may be referred to as an oxide semiconductor transistor, and a transistor including the oxide semiconductor layer ACT2 may have characteristics of an n-type transistor.

A third gate-insulating layer 143 may be positioned on the oxide semiconductor layer ACT2.

The third gate-insulating layer 143 may be positioned on the front surface of the oxide semiconductor layer ACT2 and the first interlayer insulating layer 161. However, the present disclosure is not limited thereto, and the third gate-insulating layer 143 may not be positioned on the front surface of the oxide semiconductor layer ACT2 and the first interlayer insulating layer 161.

The third gate-insulating layer 143 may include an inorganic insulating layer including silicon oxide $SiO_x$, silicon nitride $SiN_x$, silicon oxynitride $SiON_x$, or the like.

A third gate conductive layer GAT3 may be positioned on the third gate-insulating layer 143. The third gate conductive layer GAT3 may overlap a channel of the oxide semiconductor layer ACT2.

The third gate conductive layer GAT3 may include a metal or a metal alloy, such as copper Cu, molybdenum Mo, aluminum Al, titanium Ti, and may be formed as a single layer or multiple layers.

A second interlayer insulating layer 162 may be positioned on the third gate conductive layer GAT3. The second interlayer insulating layer 162 may have a single-layer structure or a multi-layer structure. The second interlayer insulating layer 162 may include an inorganic insulating material, such as silicon nitride $SiN_x$, silicon oxide $SiO_x$, and silicon nitride $SiO_xN_y$, and may include an organic material according to embodiments.

A first data conductive layer SD1 may be positioned on the second interlayer insulating layer 162. The first data conductive layer SD1 may penetrate at least one of the second interlayer insulating layer 162, the third gate-insulating layer 143, the first interlayer insulating layer 161, the second gate-insulating layer 142, or the first gate-insulating layer 141 to be connected to the source/drain region of the first semiconductor layer ACT and the source/drain region of the oxide semiconductor layer ACT2.

The first data conductive layer SD1 may include a metal or a metal alloy, such as aluminum Al, copper Cu, molybdenum Mo, titanium Ti, and may be formed of a single layer or multiple layers.

A first organic layer 181 may be positioned on the data conductive layer SD1. The first organic layer 181 may be an organic insulating layer including an organic material, and the organic material may include at least one material selected from the group consisting of polyimide, polyamide, acrylic resin, benzocyclobutene, and phenol resin.

A second data conductive layer SD2 including an anode connection member ACM may be positioned on the first organic layer 181. The anode connection member ACM may penetrate the first organic layer 181, and may be connected to the first data conductive layer SD1.

A second organic layer 182 and a third organic layer 183 are positioned on the second data conductive layer SD2, and the second organic layer 182 and the third organic layer 183 may include an opening in which an anode is positioned.

The second data conductive layer SD2 may include a metal or a metal alloy, such as aluminum (Al), copper (Cu), molybdenum (Mo), titanium (Ti), and may be formed of a single layer or multiple layers.

The second and third organic layers 182 and 183 may be organic insulating layers and may include at least one material selected from the group consisting of polyimide, polyamide, acrylic resin, benzocyclobutene, and phenol resin. In some embodiments, the third organic layer 183 may be omitted.

An anode may be positioned on the third organic layer 183. The anode connection member ACM may connect the anode positioned at the openings of the second organic layer 182 and the third organic layer 183 to the first data conductive layer SD1.

A pixel-defining layer 380 covering at least a portion of the anode while having an opening OP exposing the anode may be positioned on the anode. The pixel-defining layer 380 may be a black pixel-defining layer formed of an organic material having black color and light applied from the outside is not reflected back to the outside. That is, in the pixel-defining layer 380, according to one or more embodiments, the pixel-defining layer 380 may include a negative type of black organic material and may include a black pigment. For example, the pixel-defining layer (PDL) is propylene glycol monomethyl ether acetate (PGMEA), 3-methoxybutyl acetate (3-MBA),

A mixture including at least one of an oxime-based initiator, a multi-functional acrylate monomer, a cardo-based binder resin, a cardo-acryl-based polymer, an ester-based dispersant not including chlorine, or an acryl-based resin may be included.

A spacer 385 may be positioned above the pixel-defining layer 380. Unlike the pixel-defining layer 380, the spacer 385 may be formed of a transparent organic insulating material. According to one or more embodiments, the spacer 385 may be formed of a positive type transparent organic material. In one or more embodiments, the spacer 385 may be omitted.

A functional layer FL and a cathode are sequentially positioned on the anode and the pixel-defining layer 380, and the functional layer FL may be positioned in the entire region in the display region DA and the first component region EA1.

The cathode may be positioned in the display region DA and the component display region EDA of the first component region EA1, and may not be positioned in the light-transmitting region ETA of the first component region EA1.

The light-emitting layer EML is positioned between the functional layers FL, and the light-emitting layer EML may be positioned only within the opening OP of the pixel-defining layer 380. Hereinafter, the functional layer FL and the light-emitting layer EML may be combined to be an intermediate layer

The functional layer FL may include at least one of an auxiliary layer, such as an electron injection layer, an electron transport layer, a hole transport layer, or a hole injection layer, and a hole transport layer may be positioned under the light-emitting layer EML, and an electron transport layer and an electron injection layer may be positioned above the light-emitting layer EML.

An encapsulation layer 400 may be positioned on the cathode. The encapsulation layer 400 includes at least one inorganic layer and at least one organic layer, and may have a triple-layer structure including a first inorganic encapsulation layer, an organic encapsulation layer, and a second inorganic encapsulation layer according to embodiments. The encapsulation layer 400 may be for protecting the light-emitting layer EML from moisture or oxygen that may be introduced from the outside. According to one or more embodiments, the encapsulation layer 400 may include a structure in which an inorganic layer and an organic layer are sequentially further stacked.

Sensing insulating layers 501, 510, and 511 and a plurality of sensing electrodes 540 and 541 may be positioned on the encapsulation layer 400 for touch sensing. In one or more embodiments, a touch may be detected in a capacitive type using the two sensing electrodes 540 and 541.

For example, the first sensing insulating layer 501 may be positioned on the encapsulation layer 400, and a plurality of sensing electrodes 540 and 541 may be positioned thereon. The plurality of sensing electrodes 540 and 541 may be insulated from each other with the second sensing insulating layer 510 interposed therebetween, and some may be electrically connected through an opening positioned in the second sensing insulating layer 510.

The sensing electrodes 540 and 541 may include a metal or a metal alloy, such as aluminum (Al), copper (Cu), silver (Ag), gold (Au), molybdenum (Mo), titanium (Ti), or tantalum (Ta), and may be formed of a single layer or multiple layers. A third sensing insulating layer 511 may be positioned on the sensing electrode 540.

A light-blocking member 220 may be positioned on the sensing electrode 540 and the third sensing insulating layer 511. The light-blocking member 220 may not include carbon or the like, but may include only an organic material. For example, the light-blocking member 220 does not include carbon black, but may include a mixture containing at least one of an organic black material, such as lactam black, perylene black, or aniline black, an oxime-based initiator, a cardol-based binder resin, a monomer with a functional group, or an absorbent.

The monomer with the functional group may be, for example, any one of an acrylic monomer (or a multifunctional acrylic monomer) with four or more functional groups, an acrylic monomer (or a trifunctional acrylic monomer) with three functional groups, an acrylic monomer (or a bifunctional acrylic monomer) with two functional groups, an acrylic monomer (or a monofunctional acrylic monomer) with one functional group, or an acrylic monomer.

As described above, when the light-blocking member 220 is formed including only non-carbon-based organic materials, the infrared transmittance of the light-blocking member 220 may be (about) 90% or more. However, the material included in the light-blocking member 220 and the infrared transmittance of the light-blocking member 220 are not limited thereto, and may be variously changed.

The light-blocking member 220 may overlap the sensing electrodes 540 and 541 on a plane, and may be positioned not to overlap (e.g., may be separated in plan view from) an anode positioned in the opening OP of the pixel-defining layer 380. This may reduce or prevent the likelihood of the anode capable of displaying an image being covered by the light-blocking member 220 and the sensing electrodes 540 and 541.

The light-blocking member 220 may include an opening OPBM. The opening OPBM of the light-blocking member 220 may overlap the opening OP of the pixel-defining layer 380 in the display region DA and the component display region EDA of the first component region EA1.

In one or more embodiments, a width of the opening OPBM of the light-blocking member 220 may be different from a width of the opening OP of the pixel-defining layer 380. For example, the width of the opening OPBM of the light-blocking member 220 may be greater than the width of the opening OP of the pixel-defining layer 380. Accordingly, the light-blocking member 220 may overlap the pixel-defining layer 380 and may not overlap the light-emitting layer EML.

A color filter layer 230 may be positioned on the third sensing insulating layer 511 and the light-blocking member 220. The color filter layer 230 has a larger area than the opening OPBM of the light-blocking member 220 and may entirely cover the opening OPBM of the light-blocking member 220. A part of the color filter layer 230 may be positioned on the light-blocking member 220, and the remaining part may be positioned in the opening OPBM of the light-blocking member 220.

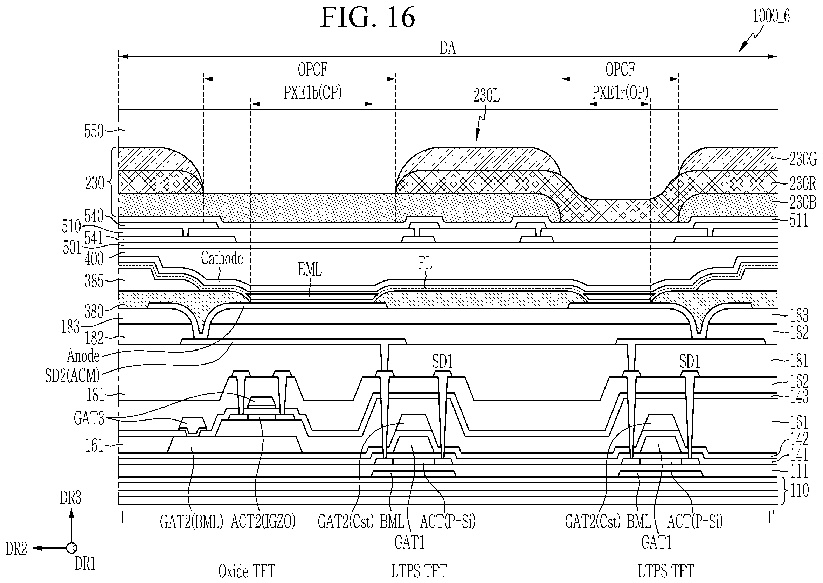

The color filter layer 230 may include a red color filter 230R that transmits red light, a green color filter that transmits green light (e.g., green color filter 230G in FIG. 16), and a blue color filter 230B that transmits blue light. The color filter layer 230 may overlap the anode of the light-emitting diode in a plan view. Light emitted from the light-emitting layer EML may be emitted while being changed to a corresponding color while passing through the color filter. Areas of the red color filter 230R, the green color filter, and the blue color filter 230B included in the color filter layer 230 may be different.

Among the red color filter 230R, the green color filter 230G, and the blue color filter 230B included in the color filter layer 230, adjacent color filters may partially overlap each other at a boundary in contact with each other. That is, some of the color filters adjacent to each other among the red color filter 230R, the green color filter 230G, and the blue color filter 230B included in the color filter layer 230 may overlap on the light-blocking member 220. For example, the edge of the blue color filter 230B positioned below the blue color filter 230B and the red color filter 230R positioned adjacent to each other may partially overlap the edge of the red color filter 230R positioned above it.

According to one or more embodiments, the color filter layer 230 may be replaced with a color conversion layer or may further include a color conversion layer. The color conversion layer may include a quantum dot. In one or more embodiments, instead of the color filter layer 230, a reflection adjustment layer filling the opening OPBM of the light-blocking member 220 may be positioned. The reflection adjustment layer may have a structure covering the light-blocking member 220.

A planarization layer 550 covering the color filter layer 230 may be positioned on the color filter layer 230, and because the color filter layer 230 and the light-blocking member 220 perform the function of reducing or preventing reflection of external light, an additional polarizer may not be attached.

Hereinafter, a stacked structure of the first component region EA1 will be described in detail. The information on the stacked structure of the first component region EA1 may be applied to the stacked structure of the second component region EA2 in substantially the same manner.

As described above, the first component region EA1 according to one or more embodiments may be positioned on the rear surface of the display panel DP, and may be a region corresponding to the first optical element ES1. Here, the first optical element ES1 may be an infrared camera as described above.

The light-transmitting region ETA may not include a semiconductor layer or a conductive layer. In addition, the light-transmitting region ETA does not include only a transparent layer but may include a layer capable of blocking visible light ray, such as the light-blocking member 220. That is, the light-transmitting region ETA overlaps the light-blocking member 220, and also overlaps the opening OBML positioned in the metal layer BML, so that the light-transmitting region ETA may not be covered by the metal layer BML.

The metal layer BML, the first semiconductor layer ACT, the first gate conductive layer GAT1, the second gate conductive layer GAT2, the oxide semiconductor layer ACT2, the third gate conductive layer GAT3, the first data conductive layer SD1, and the second data conductive layer SD2 positioned on the substrate 110 may not be positioned in the light-transmitting region ETA.

An opening OBML of a metal layer BML may be positioned on the substrate 110, a buffer layer 111 that is an inorganic insulating layer may be positioned in an opening OBML of the metal layer BML, and a first gate-insulating layer 141 and a second gate-insulating layer 142 which are inorganic insulating layers may be sequentially positioned on the buffer layer 111. In addition, a first interlayer insulating layer 161, a third gate-insulating layer 143, and a second interlayer insulating layer 162 which are inorganic insulating layers may be sequentially stacked on the second gate-insulating layer 142. A first organic layer 181, a second organic layer 182, and a third organic layer 183, which are organic insulating layers, may be sequentially stacked on the second interlayer insulating layer 162.

An overlapping portion 380ETA of the pixel-defining layer 380, which corresponds to the light-transmitting region ETA, may be positioned above the third organic layer 183. That is, the overlapping portion 380ETA of the pixel-defining layer 380 positioned in the light-transmitting region ETA may entirely overlap the light-transmitting region ETA.

A functional layer FL is positioned on the pixel-defining layer 380, a cathode positioned on the functional layer FL has an opening OPEA, and the opening OPEA may correspond to the light-transmitting region ETA. That is, the cathode may not overlap the light-transmitting region ETA of the first component region EA1. However, the arrangement of the cathode is not limited thereto and may be variously changed. For example, according to one or more embodiments, the cathode may be positioned in the entire region of the first component region EA1. That is, unlike the illustration in FIG. 10, the cathode does not include the opening OPEA corresponding to the light-transmitting region ETA, and may overlap the light-transmitting region ETA. In other words, the cathode may be positioned in front surface of the component region EDA and the light-transmitting region ETA of the first component region EA1.

In addition, according to one or more embodiments, the functional layer FL may include an opening corresponding to the light-transmitting region ETA. That is, the functional layer FL might not overlap the light-transmitting region ETA, in one or more embodiments.

An encapsulation layer 400, sensing insulating layers 501, 510, and 511 and a light-blocking member 220 may be sequentially positioned on the cathode and the functional layer FL.

The encapsulation layer 400 may have a triple-layer structure including a first inorganic encapsulation layer, an organic encapsulation layer, and a second inorganic encapsulation layer. Furthermore, the sensing insulating layers 501, 510, and 511 may all be inorganic insulating layers.

A plurality of sensing electrodes 540 and 541 may not be positioned in the light-transmitting region ETA of the first component region EA1. That is, a plurality of sensing electrodes 540 and 541 may not overlap the light-transmitting region ETA.

The light-blocking member 220 does not have an opening corresponding to the light-transmitting region ETA, and may include an overlapping portion 220ETA overlapping the light-transmitting region ETA in a plane. The overlapping portion 220ETA of the light-blocking member 220 may overlap the overlapping portion 380ETA of the pixel-defining layer 380 in the light-transmitting region ETA.

The light-blocking member 220 and the overlapping portion 220ETA serve to block visible light, but do not include an inorganic material, such as carbon and may include only an organic material to transmit a wavelength band corresponding to infrared. However, the materials included in the light-blocking member 220 and the overlapping portion 220ETA are not limited to this, and the wavelength band corresponding to infrared rays while blocking visible light can be variously changed.

The color filter layer 230 may not be positioned in the light-transmitting region ETA. That is, the overlapping portion 220ETA of the light-blocking member 220 positioned in the light-transmitting region ETA may not overlap the color filter layer 230. However, the present disclosure is not limited thereto, and according to one or more embodiments, the color filter layer 230 is positioned in the light-transmitting region ETA, and the color filter layer 230 may overlap the overlapping portion 220ETA of the light-blocking member 220.

According to a display device 1000, by maintaining the light transmittance of the first component region EA1 including the light-transmitting region ETA, and by setting the resolution and aperture ratio of the display region DA and the first component region EA1 so that the total light-emitting areas of pixels positioned in each of the display region DA and the first component region EA1 are the same or similar based on the same area, the display region DA and the first component region EA1 may have similar or equivalent brightness and lifespan.

In addition, because the light-blocking member 220 and/or the pixel-defining layer 380 including a material that blocks visible light, and that transmits a wavelength band corresponding to infrared does not include an opening that overlaps the light-transmitting region ETA positioned in the first component region EA1, recognition of the light-transmitting region ETA included in the first component region EA1 by a user may be reduced or prevented.

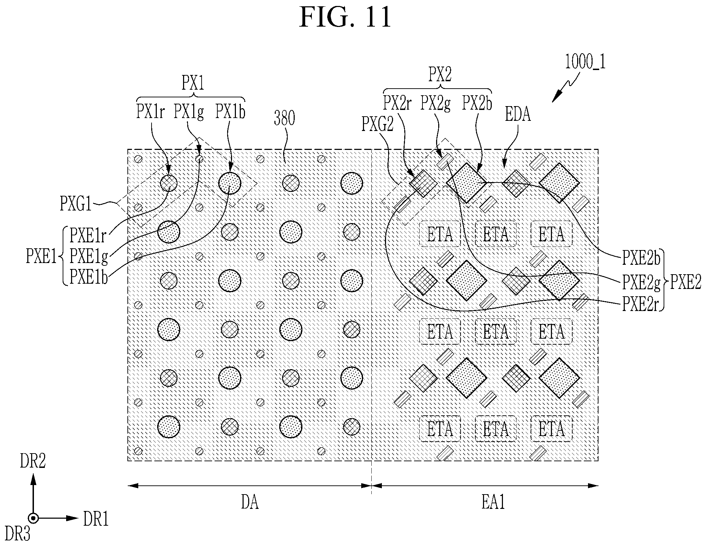

Hereinafter, a display device according to various embodiments will be described with reference to FIGS. 11 to 20. In the following, the same configuration as the previously described embodiments will be referred to by the same reference numerals, and redundant descriptions will be omitted or simplified, and differences will be mainly described.

FIG. 11 is an enlarged plan view illustrating a display region and a first component region of a display device according to some embodiments.

Referring to the display device 1000_1 shown in FIG. 11, unlike the one or more embodiments corresponding to FIG. 6, there is a difference in an overlapping relationship between the light-transmitting region ETA and the second pixel PX2 positioned in the first component region EA1.

Also, the area of the light-transmitting region ETA according to the one or more embodiments corresponding to FIG. 11 may be smaller than the area of the light-transmitting region ETA according to the one or more embodiments corresponding to FIG. 6. That is, the area of the light-transmitting region ETA shown in FIGS. 11 and 6 may be different as the type of the first optical element ES1 corresponding to the first component region EA1 according to the one or more embodiments corresponding to FIG. 11, and the first optical element ES1 corresponding to the first component region EA1 according to the one or more embodiments corresponding to FIG. 6 is different.

Alternatively, as the arrangement of a plurality of signal lines and/or metal patterns defining the light-transmitting region ETA according to the one or more embodiments corresponding to FIG. 11 or the width thereof is different from the arrangement of multiple signal lines and/or metal patterns defining the light-transmitting region ETA according to the one or more embodiments corresponding to FIG. 6, the area of the light-transmitting region ETA shown in FIG. 11 and FIG. 6 may be different.

For example, referring to FIG. 11, the plurality of light-transmitting regions ETA positioned in the first component region EA1 may not overlap the plurality of second pixels PX2 positioned in the display region DA of the first component region EA1.

More for example, according to the one or more embodiments corresponding to FIG. 11, unlike the one or more embodiments corresponding to FIG. 6, the plurality of light-transmitting regions ETA may not overlap the second-second pixels PX2g positioned on one side of the light-transmitting region ETA in the second direction DR2. For example, the plurality of light-transmitting regions ETA may overlap a part of each of the second-second pixels PX2g positioned in the first row of the component display region EDA. However, the present disclosure is not limited thereto, and according to one or more embodiments, some of the plurality of light-transmitting regions ETA may overlap some of the plurality of second pixels PX2, and the other part may not overlap the plurality of second pixels PX2.

In addition, unlike the one or more embodiments corresponding to FIG. 11, as the planar arrangement shape of the plurality of second pixels PX2 positioned in the first component region EA1 is changed according to one or more embodiments, the plurality of second pixels PX2 may not overlap the light-transmitting region ETA. For example, the positions of the plurality of second-second pixels PX2g may be changed so that the plurality of second-second pixels PX2g and the light-transmitting region ETA do not overlap in the component display region EDA of the first component region EA1.

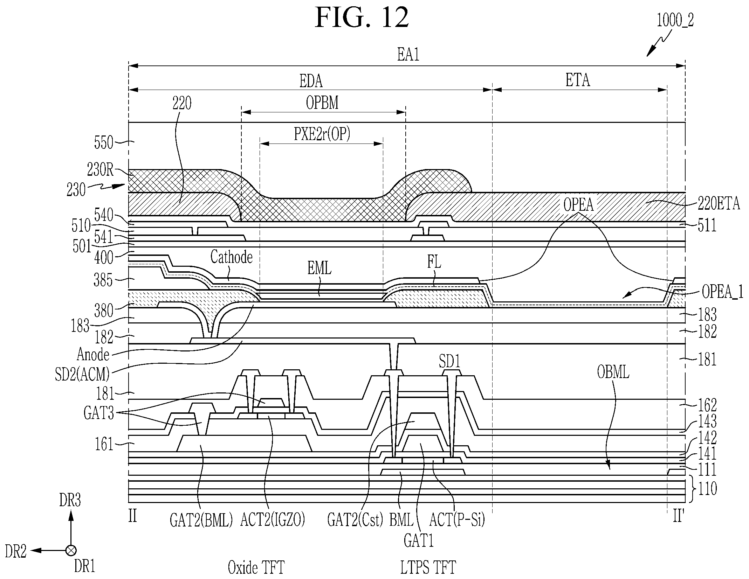

FIG. 12 is a cross-sectional view taken along the line II-II' of FIG. 6 according to some embodiments.

According to the display device 1000_2 according to the one or more embodiments corresponding to FIG. 12, unlike the one or more embodiments corresponding to FIG. 10, the pixel-defining layer 380 positioned in the first component region EA1 further includes an additional opening OPEA_1 overlapping the light-transmitting region ETA.

For example, in the light-transmitting region ETA of the first component region EA1, an additional opening OPEA_1 of the pixel-defining layer 380 may be positioned on the third organic layer 183, and the functional layer FL may be positioned within the additional opening OPEA_1 of the pixel-defining layer 380. That is, the pixel-defining layer 380 positioned in the first component region EA1 may not overlap the light-transmitting region ETA. In other words, the additional opening OPEA_1 of the pixel-defining layer 380 may correspond to the light-transmitting region ETA.

According to one or more embodiments, an additional spacer may be further located in the additional opening OPEA_1 of the pixel-defining layer 380, and located on the third organic layer 183.

A functional layer FL may be positioned in the additional opening OPEA_1 of the pixel-defining layer 380. The cathode positioned thereon may include an opening OPEA positioned corresponding to the light-transmitting region ETA. That is, the cathode may not be positioned in the light-transmitting region ETA. Although the widths of the additional opening OPEA_1 of the pixel-defining layer 380 and the opening OPEA of the cathode are shown to be different in one or more embodiments shown in FIG. 12, the widths thereof may be substantially the same according to one or more embodiments.

The encapsulation layer 400 may be positioned on the functional layer FL and the cathode. A portion of the encapsulation layer 400 may be in contact with the functional layer FL positioned within the additional opening OPEA_1 of the pixel-defining layer 380.

Sensing insulating layers 501, 510, and 511 and a light-blocking member 220 may be sequentially positioned on the encapsulation layer 400. The light-transmitting region ETA overlaps the overlapping portion 220ETA of the light-blocking member, and because the pixel-defining layer 380 has an additional opening OPEA_1 corresponding to the light-transmitting region ETA, the pixel-defining layer 380 may not be positioned in the light-transmitting region ETA. That is, the overlapping portion 220ETA of the light-blocking member 220 may not overlap the pixel-defining layer 380 in the light-transmitting region ETA.

According to the display device 1000_2, as the pixel-defining layer 380 corresponding to the light-transmitting region ETA of the first component region EA1 is removed to additionally form an additional opening OPEA_1, the transmittance of the light-transmitting region ETA may be improved.

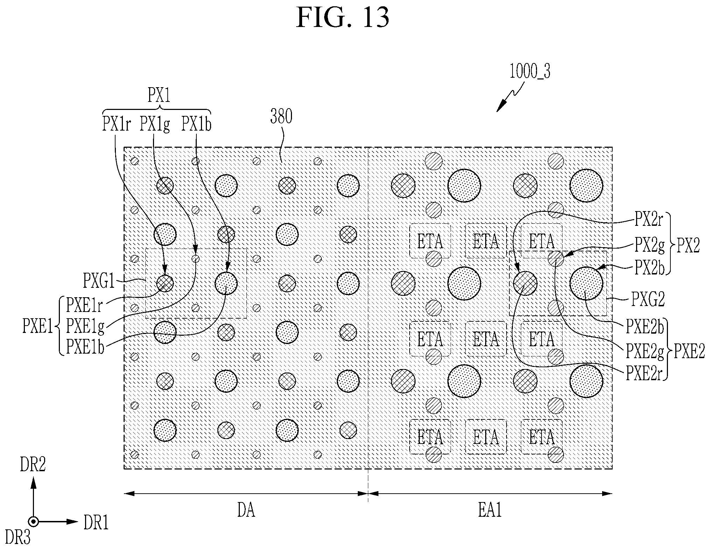

FIGS. 13 to 15 are plan views illustrating a display region and a first component region of FIG. 4 according to some embodiments.

Hereinafter, the first pixel PX1 and the second pixel PX2 positioned in each of the display region DA and the first component region EA1 will be described, and the description thereof may be substantially the same to the first light-emitting region PXE1 and the second light-emitting region PXE2 corresponding to the first pixel PX1.

According to the display device 1000_3 according to one or more embodiments illustrated in FIG. 13, unlike the one or more embodiments corresponding to FIG. 6, the planar arrangement of the plurality of first pixels PX1 positioned in the display region DA may be substantially the same as the planar arrangement of the plurality of second pixels PX2 positioned in the first component region EA1, and the area of the first pixel PX1 positioned in the display region DA may be different from the area of the second pixel PX2 positioned in the first component region EA1.

Also, according to this configuration, unlike the configuration illustrated in FIG. 6, the planar shape of the first pixel PX1 may be substantially the same as the planar shape of the second pixel PX2.

For example, the first-first pixel PX1r and the first-third pixel PX1b included in one first pixel group PXG1 positioned in the display region DA may be spaced apart from each other along the first direction DR1, and the two first-second pixels PX1g may be spaced apart from each other along the second direction DR2. The plurality of first pixel groups PXG1 may be repeatedly arranged in the display region DA.

The planar arrangement of the plurality of first pixels PX1 positioned in the display region DA may be substantially the same as the planar arrangement of the plurality of first pixels PX1 according to the one or more embodiments corresponding to FIG. 6.

The four second pixels PX2 included in one second pixel group PXG2 positioned in the first component region EA1 may be substantially the same as the configuration and arrangement of the four first pixels PX1 included in the first pixel group PXG1. That is, in one second pixel group PXG2, the second-first pixel PX2r and the second-third pixel PX2b may be positioned spaced apart from each other along the first direction DR1, and the two second-second pixels PX2g may be positioned spaced apart from each other along the second direction DR2.

A plurality of second pixel groups PXG2 may be repeatedly arranged in the first component region EA1. Because the arrangement of the plurality of first pixels PX1 constituting the first pixel group PXG1 is substantially the same as the arrangement of the plurality of second pixels PX2 constituting the second pixel group PXG2, the planar arrangement of the plurality of second pixels PX2 positioned in the first component region EA1 may be substantially the same as the planar arrangement of the plurality of first pixels PX1 positioned in the display region DA. However, because the first component region EA1 includes a plurality of light-transmitting region ETA, an interval between a plurality of second pixels PX2 spaced apart from each other with a plurality of light-transmitting region ETA interposed therebetween in the first component region EA1 may be different from an interval between the plurality of first pixels PX1 positioned in the display region DA.

As in the one or more embodiments corresponding to FIG. 6, some of the plurality of second pixels PX2 may overlap. Also, in this configuration, as in the configuration shown in FIG. 6, multiple first pixels PX1 positioned in the display region DA and second pixels PX2 positioned in the first component region EA1 may have different light-emitting areas when comparing the areas of pixels that provide the same color. The contents described above with reference to FIG. 6 may be substantially the same as each other, and thus will be omitted.

In this configuration, unlike the configuration illustrated in Fig. 6, the planar shape of the first pixel PX1 may be substantially the same as the planar shape of the second pixel PX2. The first pixel PX1 and the second pixel PX2 may have a circular, elliptical, or curved shape in a plan view. For example, as shown in FIG. 13, the first pixel PX1 and the second pixel PX2 may have a circular shape in a plan view. As another example, the first pixel PX1 may have a circular shape in a plan view, and the second pixel PX2 may have an elliptical shape in a plan view. As another example, the first pixel PX1 may have an elliptical shape on a plane, and the second pixel PX2 may have a circular shape on a plane. This is an example, and the planar shapes of the first pixel PX1 and the second pixel PX2 may be variously changed.

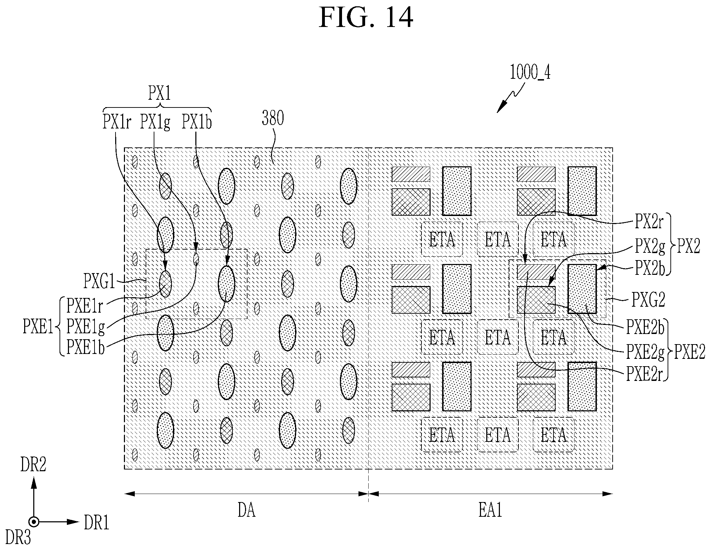

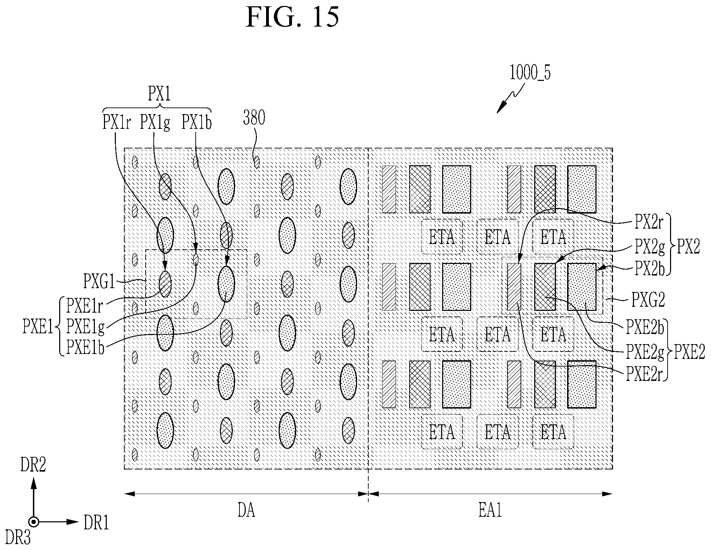

According to the display devices 1000_4 and 1000_5 according to embodiments illustrated in FIGS. 14 and 15, the first pixel PX1 positioned in the display region DA is different from the one or more embodiments corresponding to FIG. 13, and the arrangement of the plurality of second pixels PX2 positioned in the first component region EA1 and the planar shape are different.

For example, referring to FIG. 14, a planar arrangement of the plurality of first pixels PX1 positioned in the display region DA may be substantially the same as the one or more embodiments corresponding to FIG. 13. In this configuration, the planar shape of the first pixel PX1 positioned in the display region DA may be an elliptical shape. However, this is an example, and the planar shape of the first pixel PX1 positioned in the display region DA may have a circular shape or a curved shape of each side.

The second pixel group PXG2 positioned in the first component region EA1 may include three second pixels PX2, unlike the one or more embodiments corresponding to FIG. 13. That is, the three second pixels PX2 constituting one second pixel group PXG2 may be a second-first pixel PX2r, a second-second pixel PX2g, and a second-third pixel PX2b.

Here, the second-first pixel PX2r may be a red pixel for emitting red light, the second-second pixel PX2g may be a green pixel for emitting green light, and the second-third pixel PX2b may be a blue pixel for emitting blue light.

In one second pixel group PXG2, the second-first pixel PX2r may be positioned in the first row according to the first direction DR1 and the first column according to the second direction DR2, the second-second pixel PX2g may be positioned in the second row and the first column adjacent to the first row, and the second-third pixel PX2b may be positioned in the second column adjacent to the first column.

The plurality of second pixel groups PXG2 may be repeatedly arranged in the first direction DR1 and the second direction DR2 in the first component region EA1. The plurality of second pixel groups PXG2 may be arranged parallel to the light-transmitting region ETA in the component display region EDA of the first component region EA1 along the first direction DR1.

The plurality of second pixels PX2 may not overlap the plurality of light-transmitting regions ETA, unlike the one or more embodiments corresponding to FIG. 13. That is, the plurality of light-transmitting regions ETA are positioned between the plurality of second pixel groups PXG2 positioned in the component display region EDA of the first component region EA1, and may not overlap the plurality of second pixels PX2. However, this is only an example, and according to one or more embodiments, at least some of the plurality of second pixels PX2 positioned adjacent to the plurality of light-transmitting regions ETA may overlap the plurality of light-transmitting regions ETA.

In this configuration, the areas or sizes of the second-first pixel PX2r, the second-second pixel PX2g, and the second-third pixel PX2b may be different. For example, the area or size of the second-third pixel PX2b may be larger than the sizes of the second-first pixel PX2r and the second-second pixel PX2g, and the size of the second-second pixel PX2g may be larger than the size of the second-first pixel PX2r. In addition, the size of the second-third pixel PX2b may be larger than the sum of the sizes of the second-first pixel PX2r and the second-second pixel PX2g. However, this is an example, and the sizes of the second-first pixel PX2r, the second-second pixel PX2g, and the second-third pixel PX2b may be variously changed.

The plurality of second pixels PX2 may have a polygonal shape in a plan view. For example, as shown in FIG. 14, the second pixel PX2 may have a rectangular shape in a plan view. However, this is an example, and the planar shape of the plurality of second pixels PX2 may be variously changed.

Because the display device 1000_5 according to one or more embodiments illustrated in FIG. 15 is substantially the same as the display device 1000_4 according to one or more embodiments illustrated in FIG. 14, except for the planar arrangement of the second pixel PX2 positioned in the first component region EA1, the difference in the planar arrangement of the second pixel PX2 will be mainly described.

Referring to FIG. 15, the second-first pixel PX2r, the second-second pixel PX2g, and the second-third pixel PX2b included in the second pixel group PXG2 may be sequentially arranged in parallel along the first direction DR1. The second pixel group PXG2 may be repeatedly arranged along the first and second directions DR1 and DR2. Accordingly, the plurality of second pixels PX2 arranged in the first component region EA1 are arranged parallel to each other along the first direction DR1 in the component display region EDA of the first component region EA1, and may constitute one column along the first direction DR1.

In the display device 1000 according to one or more embodiments, the resolution of the display region DA and the first component region EA1 described above, the relationship between the aperture ratio of the first pixel PX1 positioned in the display region DA and the aperture ratio of the second pixel PX2 in the first component region EA1, and the numerical range of the Z value expressed above by Equation 1 regarding the relationship between the aperture ratio and the resolution of each of the display region DA and the first component region EA1, may be substantially applied to the display devices 1000_3, 1000_4, and 1000_5 according to embodiments shown in FIGS. 13 to 15. Accordingly, the display devices 1000_3, 1000_4, and 1000_5 according to embodiments illustrated in FIGS. 13 to 15 may have substantially the same aspects as those of the display device 1000 according to one or more embodiments.

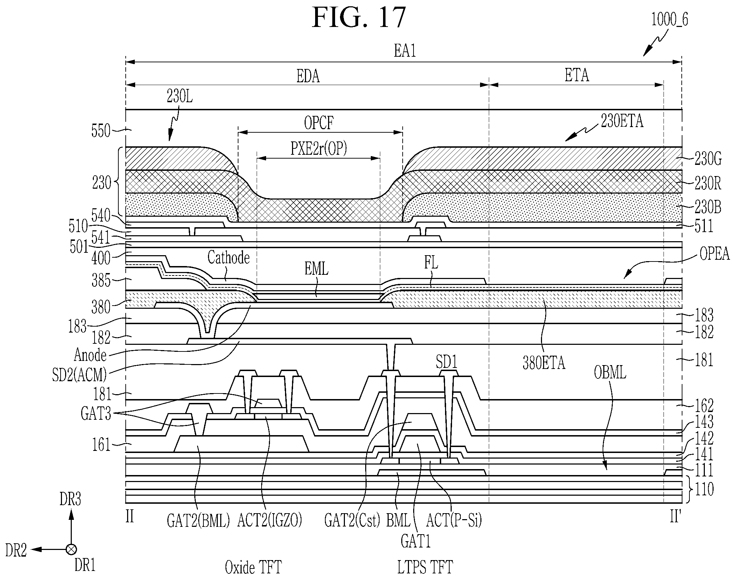

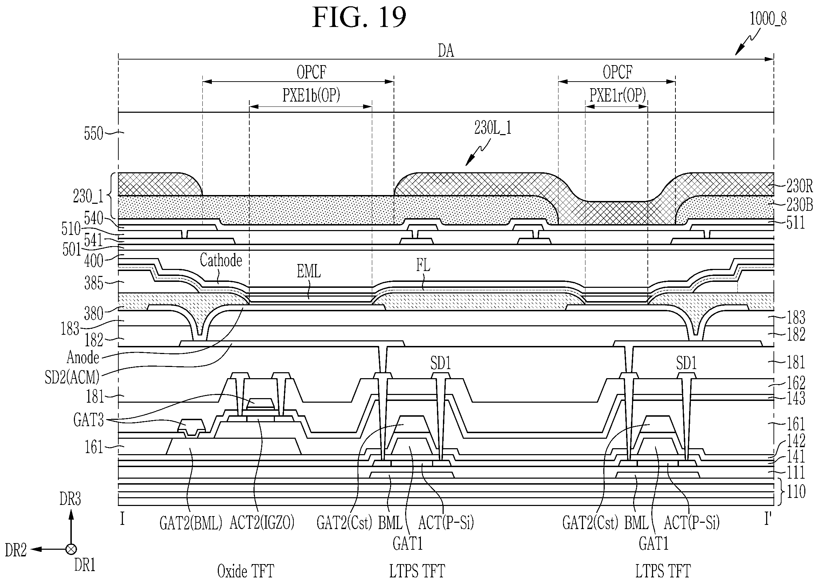

FIGS. 16 and 19 are cross-sectional views taken along the line I-I' of FIG. 6 according to some embodiments. FIGS. 17, 18, and 20 are cross-sectional views taken along the line II-II' of FIG. 6 according to some embodiments.

The display devices 1000_6, 1000_7, and 1000_8 according to embodiments illustrated in FIGS. 16 to 20 are different from the display device 1000 according to one or more embodiments in that the light-blocking member 220 is omitted. Hereinafter, the color filter layer 230 positioned in the display region DA and the first component region EA1 will be mainly described.

According to the display devices 1000_6, 1000_7 according to the embodiments illustrated in FIGS. 16 to 18, compared to the display device 1000 of other embodiments, a light-blocking member (e.g., 220 of FIG. 9) positioned in the display region DA and the first component region EA1 is omitted, and the role of the light-blocking member 220 may be performed by a color filter overlapping portion 230L in which at least two or more color filters among the color filters 230R, 230G, 230B included in the color filter layer 230 are overlapped.

According to the embodiments illustrated in FIGS. 16 to 18, the color filter overlapping portion 230L may be composed of a red color filter 230R, a green color filter 230G, and a blue color filter 230B. For example, the color filter overlapping portion 230L may have a structure in which a blue color filter 230B, a red color filter 230R, and a green color filter 230G are sequentially stacked. However, this is an example, and the type and stacking order of the color filters 230R, 230G, and 230B constituting the color filter overlapping portion 230L may be variously changed.

The color filter overlapping portion 230L may overlap the sensing electrodes 540 and 541. The color filter overlapping portion 230L includes an opening OPCF, and the opening OPCF of the color filter overlapping portion 230L may overlap the opening OP of the pixel-defining layer 380 in the display region DA and the first component display region EDA. The opening OPCF of the color filter overlapping portion 230L may mean a region between the color filter overlapping portions 230L.

Also, the opening OPCF of the color filter overlapping portion 230L may have an area or width that is larger than that of the opening OP of the pixel-defining layer 380. An anode overlapped with the opening OP of the pixel-defining layer 380 (i.e., exposed by the opening OP of the pixel-defining layer 380) may also have a structure that is not covered in a plane by the color filter overlapping portion 230L. This may reduce or prevent the likelihood of the anode and the light-emitting layer EML capable of displaying images being covered by the color filter overlapping portion 230L and the sensing electrodes 540 and 541. Any one of the color filters 230R, 230G, or 230B may be positioned in the opening OPCF of the color filter overlapping portion 230L. According to one or more embodiments, the color filters 230R, 230G, and 230B may be replaced with a color conversion layer, or may further include a color conversion layer. The color conversion layer may include a quantum dot.

A planarization layer 550 covering the color filters 230R, 230G, and 230B may be positioned on the color filter layer 230. According to one or more embodiments, a low refractive layer and an additional planarization layer may be further positioned on the planarization layer 550 to improve front visibility and light emission efficiency of the display device. Light may be refracted and emitted through the front surface by an additional planarization layer having a high refractive index and a low refractive layer. In this case, in some embodiments, the planarization layer 550 may be omitted, and a low refractive layer and an additional planarization layer may be located directly on the color filter layer 230.

Referring to FIG. 17, the color filter layer 230 does not include an opening corresponding to the light-transmitting region ETA of the first component region EA1, and may include a color filter overlapping portion 230ETA that entirely overlaps the light-transmitting region ETA of the first component region EA1.

The color filter overlapping portion 230ETA positioned in the light-transmitting region ETA may have substantially the same configuration and thickness as the color filter overlapping portion 230L positioned in the display region DA. That is, the color filter overlapping portion 230ETA positioned in the light-transmitting region ETA may include a red color filter 230R, a green color filter 230G, and a blue color filter 230B. For example, the color filter overlapping portion 230ETA positioned in the light-transmitting region ETA may have a structure in which a blue color filter 230B, a red color filter 230R, and a green color filter 230G are sequentially stacked. However, this is an example, and the configuration and stacking order of the color filters 230R, 230G, and 230B included in the color filter overlapping portion 230ETA positioned in the light-transmitting region ETA may be variously changed.

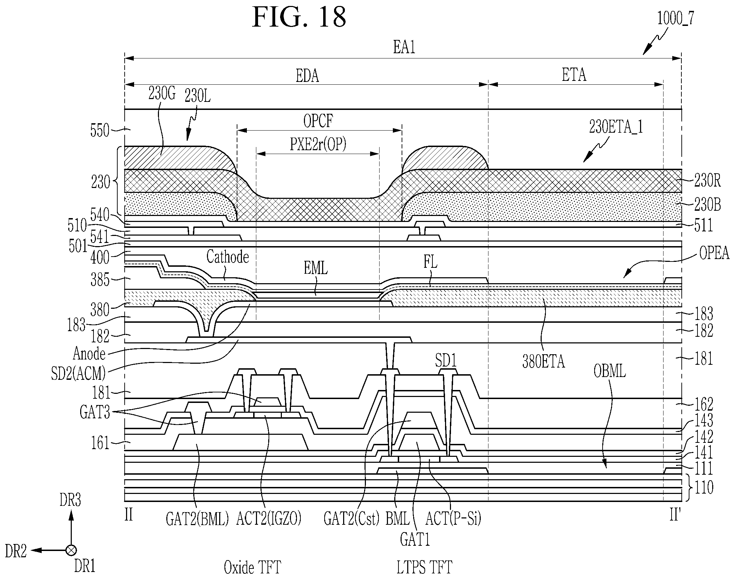

According to the display device 1000_7 according to one or more embodiments illustrated in FIG. 18, the color filter overlapping portion 230ETA_1 positioned in the light-transmitting region ETA may not include the green color filter 230G unlike the one or more embodiments corresponding to FIG. 17.

The configuration of the color filter overlapping portion 230L positioned in the component display region EDA of the first component region EA1 and the thickness and configuration of the color filter overlapping portion 230ETA_1 positioned in the light-transmitting region ETA may be different. That is, the color filter overlapping portion 230L positioned in the component display region EDA may have a structure in which a blue color filter 230B, a red color filter 230R, and a green color filter 230G are sequentially stacked, and the color filter overlapping portion 230ETA_1 positioned in the light-transmitting region ETA may have a structure in which a blue color filter 230B and a red color filter 230R are sequentially stacked. That is, the green color filter 230G may not overlap the light-transmitting region ETA.

Accordingly, the thickness of the color filter overlapping portion 230ETA positioned in the light-transmitting region ETA may be thinner than the thickness of the color filter overlapping portion 230L positioned in the component display region EDA.

According to the display device 1000_7 according to one or more embodiments illustrated in FIG. 18, the transmittance of the light-transmitting region ETA may be improved by omitting the green color filter 230G positioned in the light-transmitting region ETA.

Referring to FIGS. 17 and 18, the color filter overlapping portions 230ETA and 230ETA_1 positioned in the light-transmitting region ETA may overlap the overlapping portion 380ETA of the pixel-defining layer 380 positioned in the light-transmitting region ETA. The color filter overlapping portions 230ETA and 230ETA_1 may correspond to an overlapping portion of the light-blocking member 220 in FIG. 10 according to one or more embodiments (e.g., 220ETA in FIG. 10).

Accordingly, the color filter overlapping portions 230ETA and 230ETA_1 positioned in the light-transmitting region ETA play a role in blocking visible light, and a wavelength band corresponding to infrared rays may have a characteristic of transmitting the same.

As in the one or more embodiments corresponding to FIG. 18, the color filter overlapping portion 230ETA_1 positioned in the light-transmitting region ETA does not include the green color filter 230G, and may serve to block visible light even when only the color filter 230R and the blue color filter 230B are formed.

A functional layer FL is positioned on the pixel-defining layer 380, a cathode positioned on the functional layer FL has an opening OPEA, and the opening OPEA may correspond to the light-transmitting region ETA. That is, the cathode may not overlap the light-transmitting region ETA of the first component region EA1. However, the arrangement of the cathode is not limited thereto and may be variously changed. For example, according to one or more embodiments, the cathode may be positioned in the entire region of the first component region EA1. That is, unlike shown in FIGS. 17 and 18, the cathode does not include the opening OPEA and may overlap the light-transmitting region ETA. In other words, the cathode may be positioned in front surface of the component display region EDA and the light-transmitting region ETA of the first component region EA1.

Unlike illustrated in FIGS. 17 and 18, according to one or more embodiments, the pixel-defining layer 380 may include an additional opening OPEA_1 corresponding to the light-transmitting region ETA, like the one or more embodiments corresponding to FIG. 10. The description thereof will be omitted because the above description may be applied substantially the same.

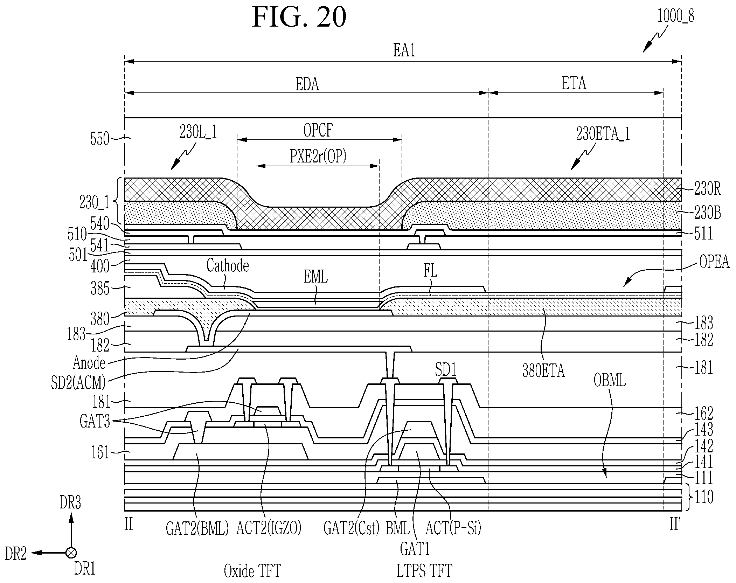

According to the display device 1000_8 according to one or more embodiments illustrated in FIGS. 19 and 20, unlike the display device 1000_6 according to one or more embodiments illustrated in FIGS. 16 and 17, the color filter overlapping portion 230L_1 of the color filter layer 230_1 does not include the green color filter 230G.

For example, referring to FIGS. 19 and 20, the color filter overlapping portion 230L_1 of the color filter layer 230_1 positioned in the component display region EDA of the display region DA and the first component region EA1 and the color filter overlapping portion 230ETA_1 positioned in the light-transmitting region ETA may not include a green color filter 230G.

The color filter overlapping portion 230L_1 positioned in the component display region EDA of the display region DA and the first component region EA1 may include a red color filter 230R and a blue color filter 230B.

In one or more embodiments, the color filter layer 230_1 includes a green color filter (e.g., green color filter 230G in FIG. 18), and in each of the component display regions EDA of the display region DA and the first component region EA1, the green color filter 230G may correspond to a plurality of first-second light-emitting regions (e.g., PXE1g in FIG. 6) and a plurality of second-third light-emitting regions (e.g., PXE2g in FIG. 6) that emit green.

The green color filter 230G may not be positioned on the color filter overlapping portion 230L_1 positioned in the display region DA and the component display region EDA and the color filter overlapping portion 230ETA_1 positioned in the light-transmitting region ETA. In other words, the color filter overlapping portion 230L_1 positioned in the display region DA and the component display region EDA and the color filter overlapping portion 230ETA_1 positioned in the light-transmitting region ETA may be composed of only a red color filter 230R and a blue color filter 230B. However, the present disclosure is not limited thereto, and the color filter overlapping portion 230L_1 positioned in the display region DA may be composed of a red color filter 230R, a green color filter 230G, and a blue color filter 230B, and the color filter overlapping portion 230L_1 positioned in the component display region EDA and the color filter overlapping portion 230ETA_1 positioned in the light-transmitting region ETA may be composed of only a red color filter 230R and a blue color filter 230B.

The display device 1000_8 according to the one or more embodiments corresponding to FIG. 19 and FIG. 20 may have substantially the same aspects as the display device 1000_7 according to the one or more embodiments corresponding to FIG. 18. In addition, because the configurations of the color filters (230R, 230G, 230B) included in the color filter overlapping portion 230L_1 positioned in the display region DA and the component display region EDA and the color filter overlapping portion 230ETA_1 positioned in the light-transmitting region ETA are identical, it is possible to reduce or prevent differing color perception depending on the region.

A display device according to one or more embodiments may be applied to various electronic devices. An electronic device according to one or more embodiments may include the display device and may further include modules or devices with additional functions other than the display device.

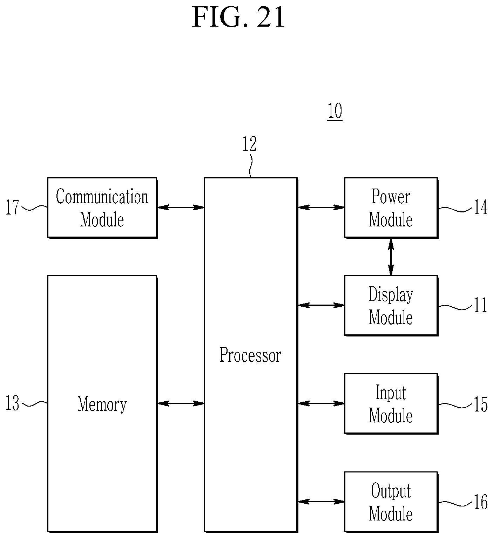

FIG. 21 is a block diagram of an electronic device according to one or more embodiments. Referring to FIG. 21, the electronic device 10 according to one or more embodiments may include a display module 11, a processor 12, a memory 13, and a power module 14. The electronic device 10 may further include an input module 15, a non-visual output module 16, and/or a communication module 17.

The electronic device 10 may output various information in the form of images through the display module 11. When the processor 12 executes an application stored in the memory 13, image information provided by the application may be provided to a user through the display module 11. The power module 14 may include a power supply module, such as a power adapter or a battery device, and a power conversion module that converts power supplied by the power supply module to generate power necessary for operation of the electronic device 10. The input module 15 may provide input information to the processor 12 and/or the display module 11. The non-visual output module 16 may receive non-image information from the processor 12, for example, sound, haptic, or light information, and may provide it to the user. The communication module 17 is a module responsible for transmitting and receiving information between the electronic device 10 and external devices, and may include a receiver and a transmitter.

At least one of the components of the above-described electronic device 10 may be included in the display device according to the above-described embodiments. Also, some of the individual modules that are functionally included in one module may be included in the display device, and other parts may be provided separately from the display device. For example, the display device may include the display module 11, and the processor 12, memory 13, and power module 14 may be provided in the form of other devices within the electronic device 10 that is not the display device.

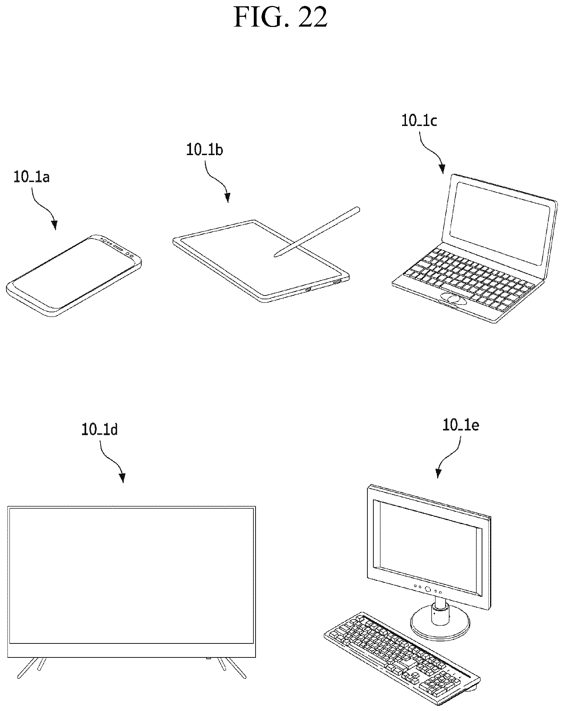

FIGS. 22 to 24 are schematic views of electronic devices according to various embodiments. FIGS. 22 to 24 illustrate examples of various electronic devices to which the display device according to the embodiments is applied.

FIG. 22 illustrates a smartphone 10_1a, a tablet PC 10_1b, a laptop 10_1c, a TV 10_1d, and a desktop monitor 10_1e as examples of electronic devices.

The smartphone 10_1a may include an input module, such as a touch sensor and a communication module in addition to the display module 11. The smartphone 10_1a may process information received through the communication module or other input modules to display information through the display module of the display device.

A tablet PC 10_1b, a laptop 10_1c, a TV 10_1d, and a desktop monitor 10_1e may include a display module and an input module similar to a smartphone 10_1a, and may further include a communication module in some cases.

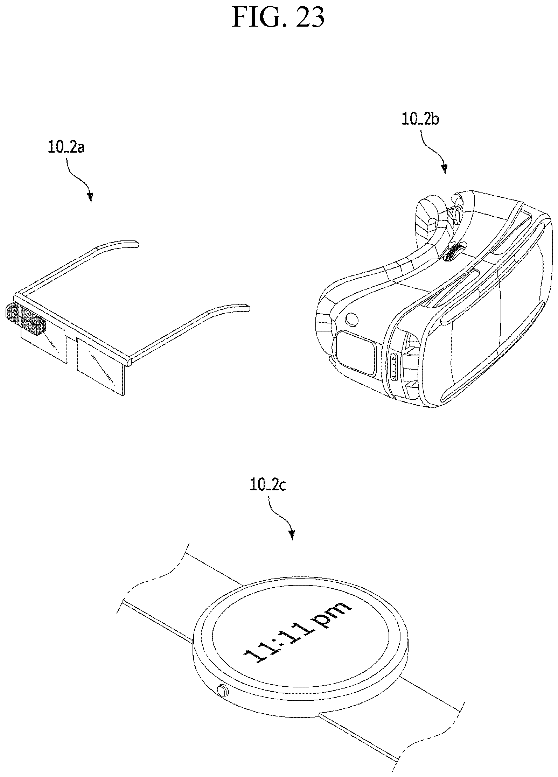

FIG. 23 shows a case where an electronic device including a display module is applied to a wearable electronic device. The wearable electronic device may be smart glasses 10_2a, a head-mounted display 10_2b, a smart watch 10_2c, or the like.

The smart glasses 10_2a and the head-mounted display 10_2b may include a display module that emits display images and a reflector that reflects the emitted display screen to provide to the user's eyes, and through this, may provide virtual reality or augmented reality screens to the user.

The smart watch 10_2c includes a biosensor as an input device, and can provide biometric information recognized through the biosensor to the user through the display module.

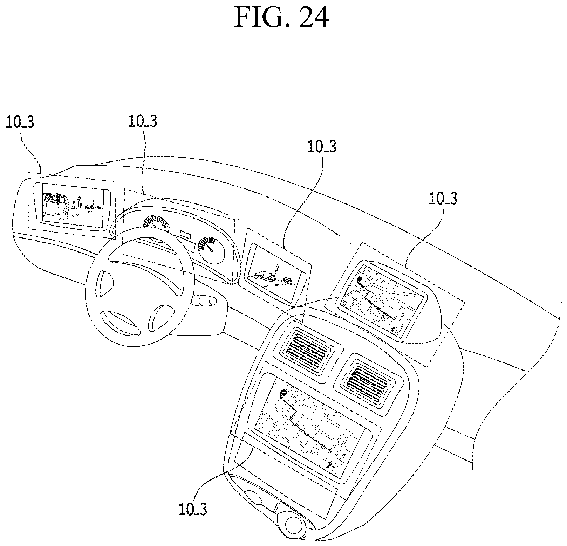

FIG. 24 shows a case where an electronic device including a display module is applied to a vehicle. For example, the electronic device 10_3 may be applied to a vehicle instrument panel, a center fascia, or may be applied to a CID (Center Information Display) placed on a vehicle dashboard or a room mirror display replacing a side mirror.

The electronic device to which the display device according to the embodiments is applied may include not only devices mainly for screen display, such as advertisement boards, electronic display boards, and game machines, but also various home appliances that display information through a display module, such as refrigerators, washing machines, dryers, air conditioners, and robot vacuum cleaners. Additionally, when the display module has a light transmission function, it may be applied to electronic devices, such as smart windows or transparent display devices that display both background and display images. The types of electronic devices according to the embodiments are not limited to the examples described above, and may be applicable to various other electronic devices not shown.

Although the embodiments of the present disclosure have been described in detail above, the scope of the present disclosure is not limited thereto, and various modifications and improvements of those skilled in the art using the basic concept of the present disclosure defined in the following claims also belong to the scope of the present disclosure.

**Description of Some of the Reference Characters**

| | | | |
|---|---|---|---|
| 1000: | display device | DP: | display panel |
| DA: | display region | EA1, EA2: | component region |
| ES: | optical element | ETA: | light-transmitting region |
| PXE1, PXE2: | light-emitting region | PX1, PX2: | pixel |
| EDA: | component display region | OPBM: | opening of light-blocking member |
| 220: | light-blocking member | 230: | color filter |
| 380: | pixel-defining layer | | |

**Claims**

1.  A display device (1000, 1000_1, 1000_2, 1000_3, 1000_4, 1000_5, 1000_6, 1000_7, 1000_8) comprising:

    a display panel (DP) comprising:

        a display region (DA) having a first resolution; and
        a component region (EA) surrounded by the display region (DA) in plan view, having a second resolution that is different from the first resolution based on a same area, and comprising a light-transmitting region (ETA);
        a pixel-defining layer (380) overlapping an anode, and defining light-emitting regions (PXE1, PXE2) comprising:

            first light-emitting regions (PXE1) in the display region (DA), and having a first aperture ratio; and
            second light-emitting regions (PXE2) in the component region (EA, EA1), and having a second aperture ratio that is different from the first aperture ratio based on a same area;

        a light-emitting layer (EML) in each of the light-emitting regions (PXE1, PXE2);
        a cathode above the pixel-defining layer (380) and the light-emitting elements;
        an encapsulation layer (400) above the cathode;
        a light-blocking member (220) above the encapsulation layer (400), the light-blocking member (220) entirely overlapping the light-transmitting region (ETA) in the component region (EA), and defining openings (OPBM) overlapping the light-emitting regions (PXE1, PXE2); and
        color filters (230B, 230G, 230R) at the openings of the light-blocking member (220), and overlapping the light-emitting regions (PXE1, PXE2); and

    an optical element (ES, ES1, ES2) on a rear surface of the component region (EA).

2.  The display device of claim 1, wherein the first aperture ratio is less than the second aperture ratio, and wherein the first resolution is greater than the second resolution.

3.  The display device of claim 2, wherein a Z value, which is expressed by a following equation, is greater than about 0.5 and less than or equal to about 1,

$$Z = \left(\frac{X0}{X1}\right) * \left(\frac{Y0}{Y1}\right)$$

X0 being the first aperture ratio, X1 being the second aperture ratio, Y0 being the second resolution, and Y1 being the first resolution.

4. The display device of one of the preceding claims, wherein the cathode defines a first opening overlapping the light-transmitting region.

5. The display device of one of the preceding claims, wherein the pixel-defining layer (380ETA) entirely overlaps the light-transmitting region (ETA), and
wherein the light-blocking member (220) in the component region (EA) overlaps the pixel-defining layer (380).

6. The display device of one of the preceding claims, wherein the pixel-defining layer (380) comprises a black pixel-defining layer.

7. The display device of claim 4, wherein the pixel-defining layer (380) defines a second opening overlapping the light-transmitting region.

8. The display device of one of the preceding claims, wherein a first planar shape of the first light-emitting regions (PXE1) is different from a second planar shape of the second light-emitting regions (PXE2).

9. The display device of claim 8, wherein the first planar shape comprises an ellipse or a circle, and
wherein the second planar shape comprises a square.

10. The display device of one of claims 8 or 9, wherein a first planar arrangement of the first light-emitting regions (PXE1) and a second planar arrangement of the second light-emitting regions (PXE2) are different.

11. The display device of one of claims 1 to 7, wherein the first light-emitting regions (PXE1) and the second light-emitting regions (PXE2) have a curved planar shape comprising an ellipse or a circle, and
wherein the first light-emitting regions and the second light-emitting regions have a same planar arrangement.

12. The display device of one of the preceding claims, wherein the component region (EA) comprises a first component region (EA1) and a second component region (EA2) comprising light-transmitting regions (ETA), and
wherein a number and/or, density and/or, and/or size of one of the light-transmitting regions at the first component region (EA1) is different from that of one of the light-transmitting regions at the second component region (EA2).

13. The display device of claim 12, further comprising third light-emitting regions (PXE3) having the first aperture ratio at the second component region (EA2),

wherein the second light-emitting regions (PXE2) at the first component region (EA1) , and
wherein a resolution of the first light-emitting regions (PXE1) is substantially equal to a resolution of the third light-emitting regions (PXE3) based on a same area.

14. The display device of one of the preceding claims, wherein the light-blocking member (220) comprises two or more of the color filters (230B, 230G, 230R).

15. The display device of claim 14, wherein the two or more of the color filters (230B, 230G, 230R) comprise a red color filter (230B, 230G, 230R) and a blue color filter (230B).

# FIG. 1

# FIG. 2

# FIG. 3

PM
Power supply module

1000

EM1

TM2 — Receiver

Transmitter

TM    TM1    CM

Control module

IIM — Image input module

AIM — Audio input module

MM — Memory

IF — External interface

DP

Display pixel — DA

Touch sensor — TS

EM2

Audio output module — AOM

Light emitting module — LM

Light receiving module — LRM

Camera module — CMM

# FIG. 4

# FIG. 5

# FIG. 6

EP 4 686 357 A1

# FIG. 7

EP 4 686 357 A1

# FIG. 8

# FIG. 9

FIG. 10

# FIG. 11

EP 4 686 357 A1

# FIG. 12

1000_2

EP 4 686 357 A1

# FIG. 13

# FIG. 14

EP 4 686 357 A1

# FIG. 15

EP 4 686 357 A1

# FIG. 16

EP 4 686 357 A1

# FIG. 17

EP 4 686 357 A1

# FIG. 18

EP 4 686 357 A1

# FIG. 19

EP 4 686 357 A1

# FIG. 20

# FIG. 21

# FIG. 22

# FIG. 23

10_2a

10_2b

10_2c

# FIG. 24

Europäisches
Patentamt
European
Patent Office
Office européen
des brevets

# EUROPEAN SEARCH REPORT

**Application Number**

EP 25 17 2617

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2024/032356 A1 (IN YUN-KYEONG [KR] ET AL) 25 January 2024 (2024-01-25) * paragraphs [0071], [0077], [0089], [0117], [0209], [0253]; figures 1,4-22 * | 1-15 | INV. H10K59/121 H10K59/35 H10K59/38 H10K59/80 H10K50/86 |
| Y | US 2024/168353 A1 (ZHANG SHUAI [CN]) 23 May 2024 (2024-05-23) * paragraphs [0032], [0033], [0035], [0040]; figures 1,2,3,8 * | 1-15 | |
| Y | CN 116 456 779 A (BOE TECHNOLOGY GROUP CO LTD; CHENGDU BOE OPTOELECT TECH CO) 18 July 2023 (2023-07-18) * paragraphs [0003] - [0010], [0047] - [0064]; figure 2 * | 1-15 | |
| Y | US 2021/066648 A1 (CHUNG JIN KOO [KR] ET AL) 4 March 2021 (2021-03-04) * paragraphs [0068], [0122], [0126] - [0128]; figures 3,5,11,12 * | 1-15 | |
| Y | US 2024/074246 A1 (CHOI KYUNG HYUN [KR]) 29 February 2024 (2024-02-29) * figure 6 * | 9 | **TECHNICAL FIELDS SEARCHED (IPC)** H10K |
| Y | US 2022/238849 A1 (OH JAE-YOUNG [KR] ET AL) 28 July 2022 (2022-07-28) * paragraphs [0069], [0070]; figures 18,19 * | 12,13 | |
| Y | US 2024/049535 A1 (KIM JONG SEOK [KR] ET AL) 8 February 2024 (2024-02-08) * paragraphs [0059] - [0062]; figures 4,5 * | 14,15 | |

The present search report has been drawn up for all claims

| Place of search | Date of completion of the search | Examiner |
|---|---|---|
| The Hague | 2 October 2025 | Faou, Marylène |

EPO FORM 1503 03.82 (P4C01)

## ANNEX TO THE EUROPEAN SEARCH REPORT
## ON EUROPEAN PATENT APPLICATION NO.

EP 25 17 2617

This annex lists the patent family members relating to the patent documents cited in the above-mentioned European search report.
The members are as contained in the European Patent Office EDP file on
The European Patent Office is in no way liable for these particulars which are merely given for the purpose of information.

02-10-2025

| Patent document cited in search report | | | Publication date | Patent family member(s) | | Publication date |
|---|---|---|---|---|---|---|
| US | 2024032356 | A1 | 25-01-2024 | CN | 117440719 A | 23-01-2024 |
| | | | | KR | 20240013951 A | 31-01-2024 |
| | | | | US | 2024032356 A1 | 25-01-2024 |
| US | 2024168353 | A1 | 23-05-2024 | CN | 115020445 A | 06-09-2022 |
| | | | | EP | 4280845 A1 | 22-11-2023 |
| | | | | US | 2024168353 A1 | 23-05-2024 |
| | | | | WO | 2023071523 A1 | 04-05-2023 |
| CN | 116456779 | A | 18-07-2023 | CN | 116456779 A | 18-07-2023 |
| | | | | WO | 2024245246 A1 | 05-12-2024 |
| US | 2021066648 | A1 | 04-03-2021 | CN | 112447802 A | 05-03-2021 |
| | | | | EP | 3823032 A1 | 19-05-2021 |
| | | | | JP | 7477357 B2 | 01-05-2024 |
| | | | | JP | 2021039328 A | 11-03-2021 |
| | | | | KR | 20210028296 A | 12-03-2021 |
| | | | | KR | 20250049532 A | 11-04-2025 |
| | | | | US | 2021066648 A1 | 04-03-2021 |
| US | 2024074246 | A1 | 29-02-2024 | CN | 220858823 U | 26-04-2024 |
| | | | | KR | 20240031448 A | 08-03-2024 |
| | | | | US | 2024074246 A1 | 29-02-2024 |
| US | 2022238849 | A1 | 28-07-2022 | CN | 112925434 A | 08-06-2021 |
| | | | | KR | 20210070516 A | 15-06-2021 |
| | | | | US | 2021175476 A1 | 10-06-2021 |
| | | | | US | 2022238849 A1 | 28-07-2022 |
| US | 2024049535 | A1 | 08-02-2024 | CN | 117525107 A | 06-02-2024 |
| | | | | CN | 220359682 U | 16-01-2024 |
| | | | | KR | 20240020298 A | 15-02-2024 |
| | | | | US | 2024049535 A1 | 08-02-2024 |

EPO FORM P0459

For more details about this annex : see Official Journal of the European Patent Office, No. 12/82